# EUROPEAN PATENT APPLICATION

(11) **EP 4 376 088 A1**
(43) Date of publication of application: **29.05.2024**
(21) Application number: 23191480.5
(22) Date of filing: 15.08.2023
(51) Int. Cl.: H01L 29/06, H01L 27/088, H01L 29/423, H01L 21/336, H01L 29/775, H01L 29/78, H01L 21/285

(54) **SEMICONDUCTOR DEVICE**

(30) Priority: 24.11.2022 KR 20220159310
(71) Applicant: Samsung Electronics Co., Ltd., Suwon-si, Gyeonggi-do 16677 (KR)
(72) Inventor: YOO, Hyumin, 16677 Suwon-si (KR); PARK, Beomjin, 16677 Suwon-si (KR); KANG, Myung Gil, 16677 Suwon-si (KR); KIM, Dongwon, 16677 Suwon-si (KR); KIM, Younggwon, 16677 Suwon-si (KR)
(74) Representative: Marks & Clerk LLP

(57) **Abstract**

Disclosed is a semiconductor device comprising a substrate including an active pattern, a channel pattern on the active pattern and including semiconductor patterns spaced apart from and vertically stacked on each other, a source/drain pattern connected to the semiconductor patterns having a p-type, a gate electrode on the semiconductor patterns and including inner electrodes between neighboring semiconductor patterns and an outer electrode on an uppermost semiconductor pattern, and a gate dielectric layer between the gate electrode and the semiconductor patterns and including an inner gate dielectric layer adjacent to the inner electrode and an outer gate dielectric layer that extends from bottom to lateral surfaces of the outer electrode. The outer electrode and the outer gate dielectric layer have an inverted T shape.

## Description

### BACKGROUND

### 1. Field

Embodiments relate to a semiconductor device, and more particularly, to a semiconductor device including a field effect transistor.

### 2. Description of the Related Art

A semiconductor device may include an integrated circuit including metal oxide semiconductor field effect transistors (MOSFETs). As sizes and design rules of the semiconductor device are gradually decreased, sizes of the MOSFETs are also increasingly scaled down. The scale down of MOSFETs may deteriorate operating characteristics of the semiconductor device. Accordingly, various studies have been conducted to develop methods of fabricating semiconductor devices having superior performances while overcoming limitations caused by high integration of the semiconductor devices.

### SUMMARY

Embodiments may provide a semiconductor device having increased reliability.

Some embodiments may provide a semiconductor device with improved electrical properties.

According to some embodiments, a semiconductor device may include a substrate that includes an active pattern; a channel pattern on the active pattern, the channel pattern including a plurality of semiconductor patterns that are spaced apart from and vertically stacked on each other; a source/drain pattern connected to the plurality of semiconductor patterns each of which has a p-type; a gate electrode on the plurality of semiconductor patterns, the gate electrode including inner electrodes between neighboring ones of the plurality of semiconductor patterns and an outer electrode on an uppermost semiconductor pattern; and a gate dielectric layer between the gate electrode and the plurality of semiconductor patterns, the gate dielectric layer including an inner gate dielectric layer adjacent to the inner electrode and an outer gate dielectric layer that extends from a bottom surface of the outer electrode to a lateral surface of the outer electrode. The outer electrode and the outer gate dielectric layer may have an inverted T shape.

According to some embodiments, a semiconductor device may include: a first active pattern on an NMOSFET region and a second active pattern on a PMOSFET region; a first channel pattern on the first active pattern and a second channel pattern on the second active pattern, each of the first and second channel patterns including a plurality of semiconductor patterns that are spaced apart from and vertically stacked on each other; a first source/drain pattern connected to the first channel pattern and a second source/drain pattern connected to the second channel pattern; a first gate electrode on the first channel pattern and a second gate electrode on the second channel pattern, each of the first and second gate electrodes including inner electrodes between neighboring ones of the plurality of semiconductor patterns and an outer electrode on an uppermost semiconductor pattern; and a first active contact electrically connected to the first source/drain pattern and a second active contact electrically connected to the second source/drain pattern. A first height of the first source/drain pattern may be less than a second height of the second source/drain pattern. A first recess depth of the first source/drain pattern defined by the first active contact may be greater than a second recess depth of the second source/drain pattern defined by the second active contact.

According to some embodiments, a semiconductor device include: a substrate that includes a first active region and a second active region; a device isolation layer that defines a first active pattern on the first active region and a second active pattern on the second active region; a first channel pattern on the first active pattern and a second channel pattern on the second active pattern, each of the first and second channel patterns including a plurality of semiconductor patterns that are spaced apart from and vertically stacked on each other; a first source/drain pattern connected to the first channel pattern and a second source/drain pattern connected to the second channel pattern; a first gate electrode on the first channel pattern and a second gate electrode on the second channel pattern, each of the first and second gate electrodes including inner electrodes between neighboring ones of the plurality of semiconductor patterns and an outer electrode on an uppermost semiconductor pattern; a gate dielectric layer between the plurality of semiconductor patterns and the first and second gate electrodes, the gate dielectric layer including an inner gate dielectric layer adjacent to the inner electrode and an outer gate dielectric layer adjacent to the outer electrode; an inner spacer between the gate dielectric layer and the first source/drain pattern; a gate spacer on a sidewall of each of the first and second gate electrodes; a gate capping pattern on a top surface of each of the first and second gate electrodes; an interlayer dielectric layer on the gate capping pattern; a first active contact that penetrates the interlayer dielectric layer to come into electrical connection with the first source/drain pattern and a second active contact that penetrates the interlayer dielectric layer to come into electrical connection with the second source/drain pattern; a metal-semiconductor compound layer between each of the first and second active contacts and each of the first and second source/drain patterns; a gate contact that penetrates the interlayer dielectric layer and the gate capping pattern to come into electrical connection with each of the first and second gate electrodes; a first metal layer on the interlayer dielectric layer, the first metal layer including a power line and first wiring lines, the first wiring lines being correspondingly electrically to the first active contact, the second active contact, and the gate contact; and a second metal layer on the first metal layer, the second metal layer including second wiring lines electrically connected to the first metal layer. A bottom surface of the first active contact may be lower than the uppermost semiconductor pattern of the first channel pattern. A bottom surface of the second active contact may be higher than the uppermost semiconductor pattern of the second channel pattern.

At least some of the above and other features of the invention are set out in the claims.

### BRIEF DESCRIPTION OF THE DRAWINGS

Features will become apparent to those of skill in the art by describing in detail embodiments with reference to the attached drawings in which:
FIGS. 1 to 3 illustrate conceptual views showing logic cells of a semiconductor device according to some embodiments.
FIG. 4 illustrates a plan view showing a semiconductor device according to some embodiments.
FIGS. 5A, 5B, 5C, and 5D illustrate cross-sectional views respectively taken along lines A-A', B-B', C-C', and D-D' of FIG. 4.
FIG. 6A illustrates an enlarged view showing section M of FIG. 5A.
FIG. 6B illustrates an enlarged view showing an example of section N depicted in FIG. 5B.
FIGS. 7A, 7B, 7C, 8A, 8B, 8C, 9A, 9B, 9C, 10A, 10B, 10C, 11A, 11B, 11C, 12A, 12B, 12C, 13A, 13B, 13C, 13D, 14A, 14B, 14C, 14D, 15A, 15B, 15C, and 15D illustrate cross-sectional views showing a method of fabricating a semiconductor device according to some embodiments.

### DETAILED DESCRIPTION

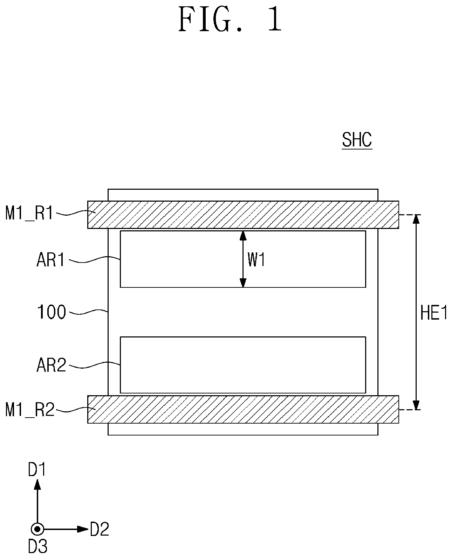

FIGS. 1 to 3 illustrate conceptual views showing logic cells of a semiconductor device according to some embodiments.

Referring to FIG. 1, a single height cell SHC may be provided. For example, a substrate 100 may be provided thereon with a first power line M1_R1 and a second power line M1_R2. The first power line M1_R1 may be a path for providing a source voltage VSS, for example, a ground voltage. The second power line M1_R2 may be a path for providing a drain voltage VDD, for example, a power voltage.

The single height cell SHC may be defined between the first power line M1_R1 and the second power line M1_R2. The single height cell SHC may include one first active region AR1 and one second active region AR2. One of the first and second active regions AR1 and AR2 may be a PMOSFET region, and the other of the first and second active regions AR1 and AR2 may be an NMOSFET region. For example, the single height cell SHC may have a complementary metal oxide semiconductor (CMOS) structure provided between the first power line M1_R1 and the second power line M1_R2.

Each of the first and second active regions AR1 and AR2 may have a first width W1 in a first direction D1. A first height HE1 may be defined as a length in the first direction D1 of the single height cell SHC. The first height HE1 may be substantially the same as a distance (e.g., pitch) between the first power line M1_R1 and the second power line M1_R2.

The single height cell SHC may constitute one logic cell. In this description, the term "logic cell" may refer to a logic device, such as AND, OR, XOR, XNOR, and inverter, that performs a specific function. For example, the logic cell may include transistors for constituting a logic device, and may also include wiring lines that connect the transistors to each other.

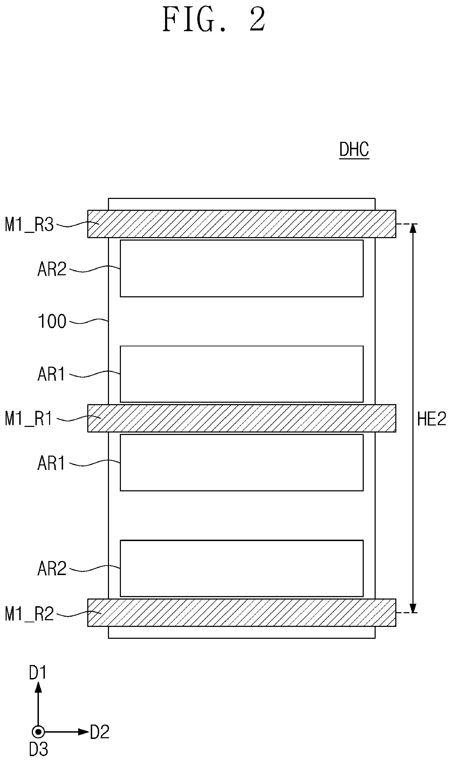

Referring to FIG. 2, a double height cell DHC may be provided. For example, a substrate 100 may be provided thereon with a first power line M1_R1, a second power line M1_R2, and a third power line M1_R3. The first power line M1_R1 may be disposed between the second power line M1_R2 and the third power line M1_R3. The third power line M1_R3 may be a path for providing a source voltage VSS.

The double height cell DHC may be defined between the second power line M1_R2 and the third power line M1_R3. The double height cell DHC may include two first active regions AR1 and two second active regions AR2.

One of the two second active regions AR2 may be adjacent to the second power line M1_R2. The other of the two second active regions AR2 may be adjacent to the third power line M1_R3. The two first active regions AR1 may be adjacent to the first power line M1_R1. When viewed in a plan view, the first power line M1_R1 may be disposed between the two first active regions AR1.

A second height HE2 may be defined to indicate a length in the first direction D1 of the double height cell DHC. The second height HE2 may be about twice the first height HE1 of FIG. 1. The two first active regions AR1 of the double height cell DHC may be collectively connected together to act as one active region.

In some embodiments, the double height cell DHC shown in FIG. 2 may be defined as a multi-height cell. Although not shown, the multi-height cell may include a triple height cell whose cell height is about three times that of the single height cell SHC.

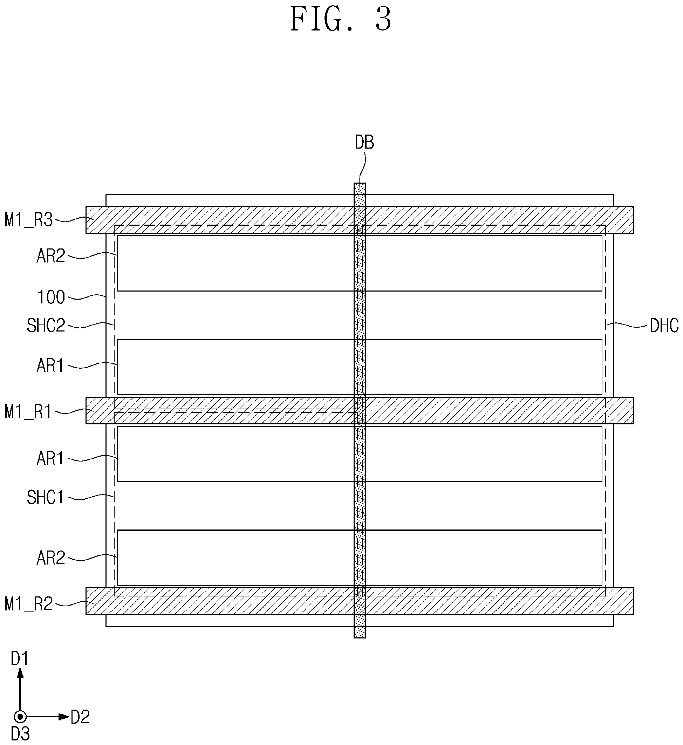

Referring to FIG. 3, a substrate 100 may be provided thereon with a first single height cell SHC1, a second single height cell SHC2, and a double height cell DHC that are two-dimensionally disposed. The first single height cell SHC1 may be disposed between a first power line M1_R1 and a second power line M1_R2. The second single height cell SHC2 may be disposed between the first power line M1_R1 and a third power line M1_R3. The second single height cell SHC2 may be adjacent in a first direction D1 to the first single height cell SHC1.

The double height cell DHC may be disposed between the second power line M1_R2 and the third power line M1_R3. The double height cell DHC may be adjacent in a second direction D2 to the first and second single height cells SHC1 and SHC2.

A separation structure DB may be provided between the first single height cell SHC1 and the double height cell DHC and between the second single height cell SHC2 and the double height cell DHC. The separation structure DB may electrically separate an active region of the double height cell DHC from an active region of each of the first and second single height cells SHC1 and SHC2.

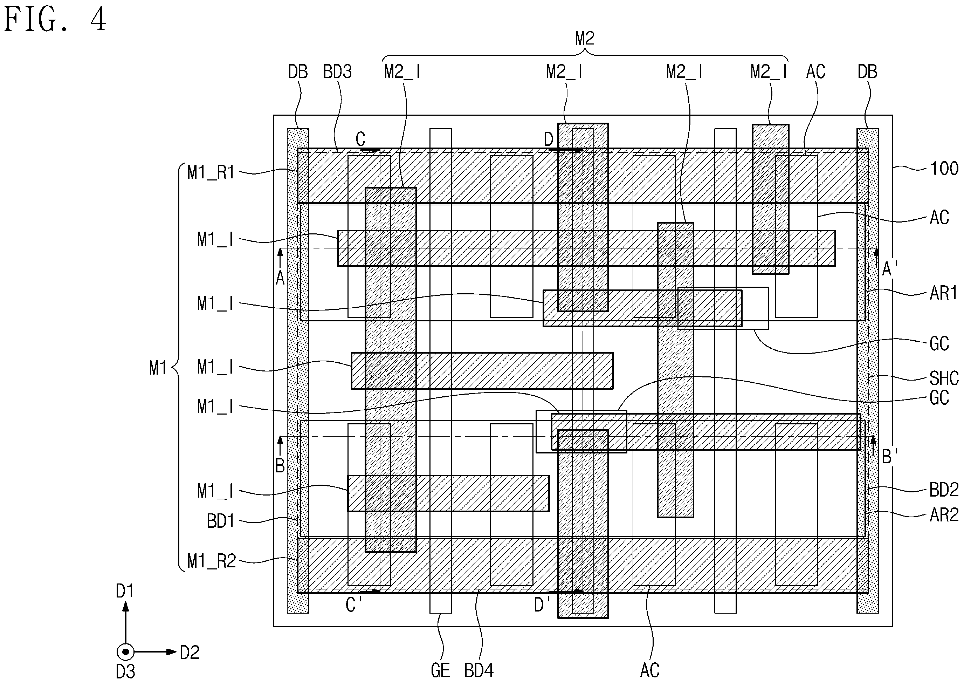

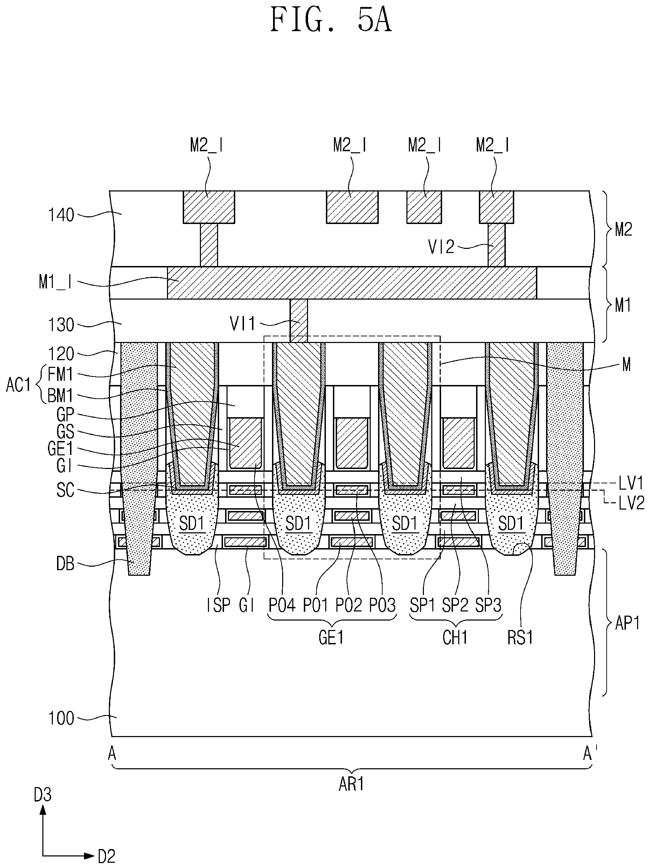

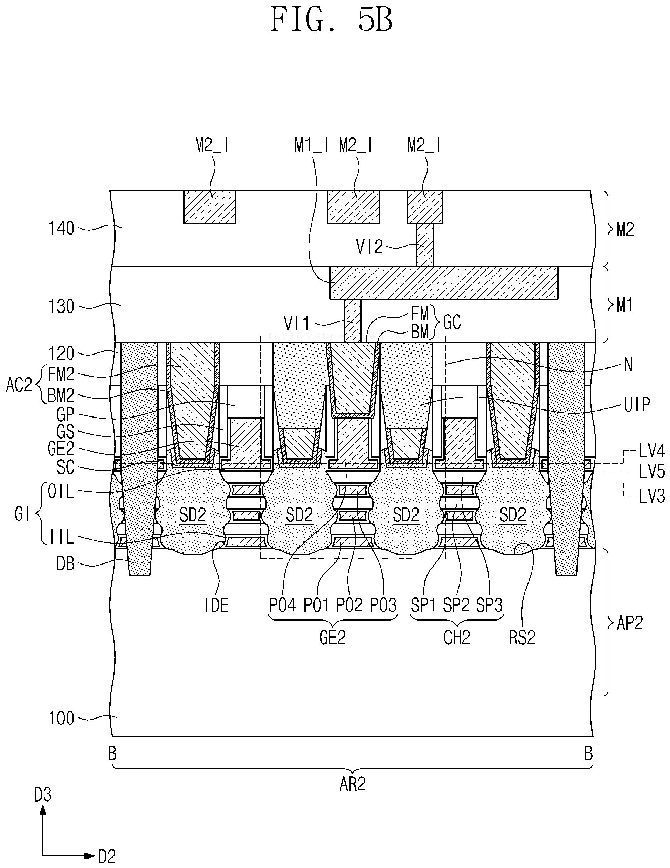

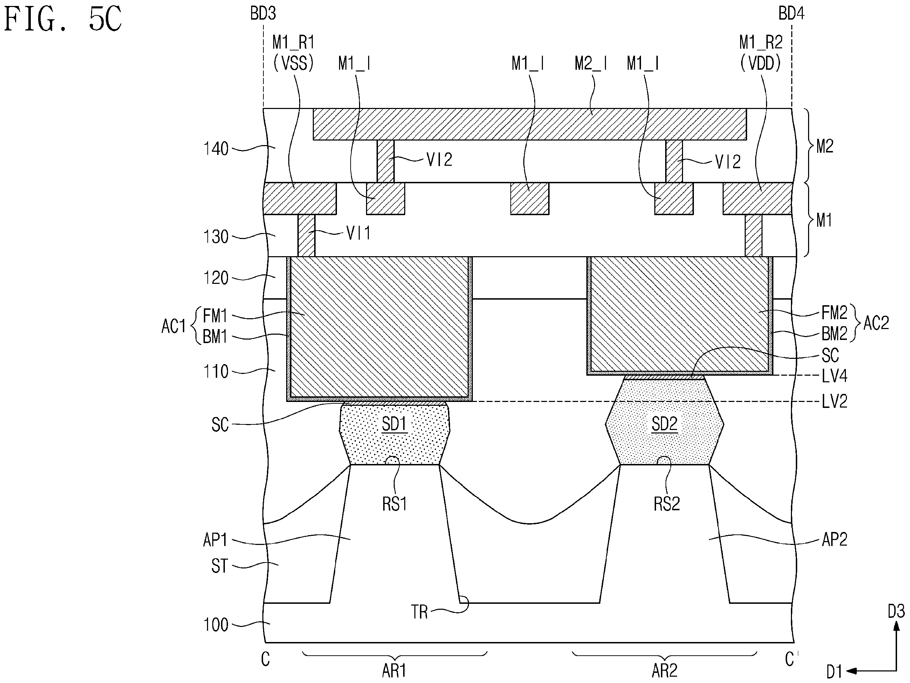

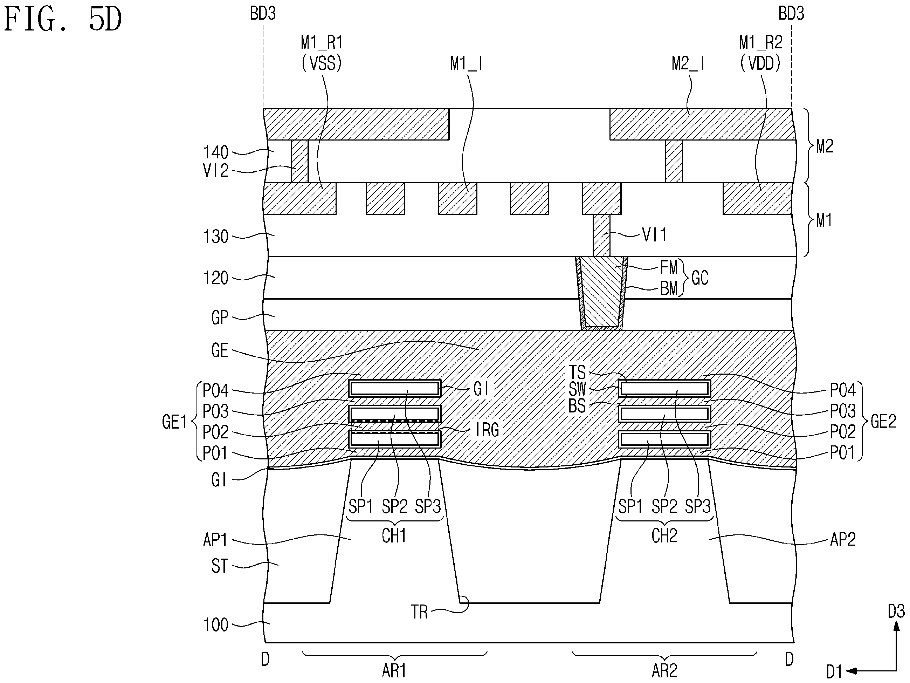

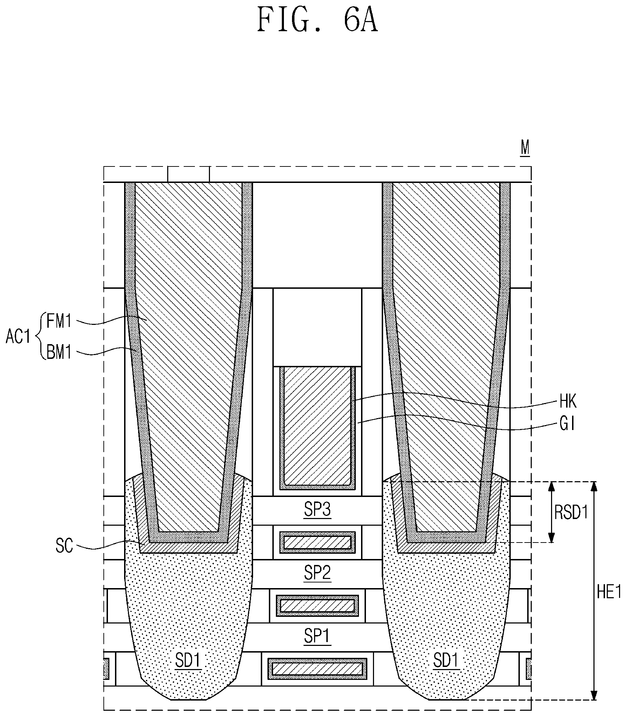

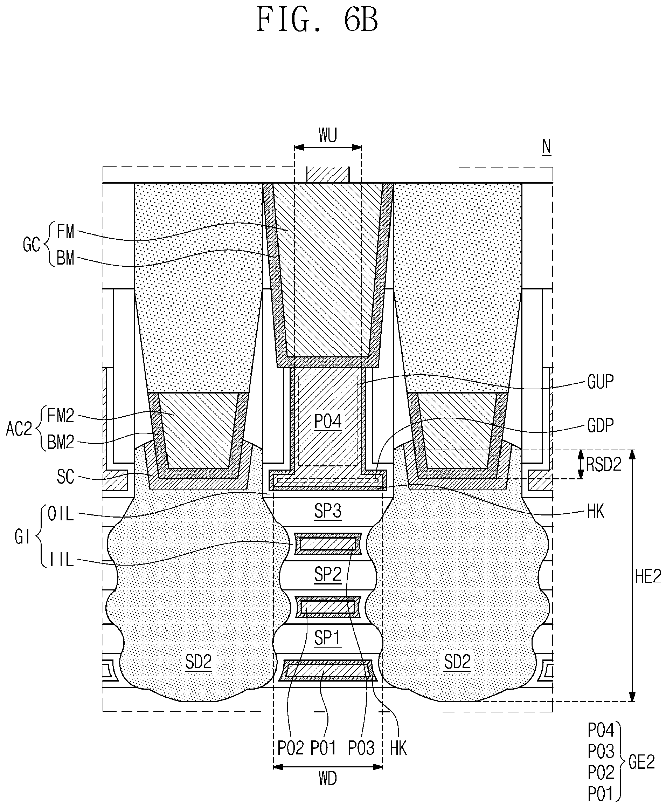

FIG. 4 illustrates a plan view showing a semiconductor device according to some embodiments. FIGS. 5A, 5B, 5C, and 5D illustrate cross-sectional views respectively taken along lines A-A', B-B', C-C', and D-D' of FIG. 4. FIG. 6A illustrates an enlarged view showing an example of section M depicted in FIG. 5A. FIG. 6B illustrates an enlarged view showing an example of section N depicted in FIG. 5B. A semiconductor device depicted in FIGS. 4 and 5A to 5D is a detailed example of the single height cell SHC shown in FIG. 1.

Referring to FIGS. 4 and 5A to 5D, a single height cell SHC may be provided on a substrate 100. The single height cell SHC may be provided thereon with logic transistors included in a logic circuit. The substrate 100 may be a compound semiconductor substrate or a semiconductor substrate including silicon, germanium, or silicon-germanium. For example, the substrate 100 may be a silicon substrate.

The substrate 100 may include a first active region AR1 and a second active region AR2. Each of the first and second active regions AR1 and AR2 may extend in a second direction D2. In an embodiment, the first active region AR1 may be an NMOSFET region, and the second active region AR2 may be a PMOSFET region.

A first active pattern AP1 and a second active pattern AP2 may be defined by a trench TR formed on an upper portion of the substrate 100. The first active pattern AP1 may be provided on the first active region AR1, and the second active pattern AP2 may be provided on the second active region AR2. The first and second active patterns AP1 and AP2 may extend in the second direction D2. The first and second active patterns AP1 and AP2 may be vertically protruding portions of the substrate 100.

A device isolation layer ST may be provided on the substrate 100. The device isolation layer ST may fill the trench TR. The device isolation layer ST may include a silicon oxide layer. The device isolation layer ST may not cover any of first and second channel patterns CH1 and CH2, as will be discussed below.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3 that are sequentially stacked. The first, second, and third semiconductor patterns SP1, SP2, and SP3 may be spaced apart from each other in a vertical direction (or a third direction D3).

Each of the first, second, and third semiconductor patterns SP1, SP2, and SP3 may include silicon (Si), germanium (Ge), or silicon-germanium (SiGe). For example, each of the first, second, and third semiconductor patterns SP1, SP2, and SP3 may include crystalline silicon, for example, monocrystalline silicon. In an embodiment, the first, second, and third semiconductor patterns SP1, SP2, and SP3 may be stacked nano-sheets. The first, second, and third semiconductor patterns SP1, SP2, and SP3 of the first channel pattern CH1 may have a height in the third direction D3 that is the same as the height in the third direction D3 of the first, second, and third semiconductor patterns SP1, SP2, and SP3 of the second channel pattern CH2.

A plurality of first source/drain patterns SD1 may be provided on the first active pattern AP1. A plurality of first recesses RS1 may be formed on an upper portion of the first active pattern AP1. The first source/drain patterns SD1 may be correspondingly provided in the first recesses RS1. The first source/drain patterns SD1 may be impurity regions of a first conductivity type (e.g., n-type). The first channel pattern CH1 may be interposed between a pair of first source/drain patterns SD1. For example, the pair of first source/drain patterns SD1 may be connected to each other through the stacked first, second, and third semiconductor patterns SP1, SP2, and SP3.

A plurality of second source/drain patterns SD2 may be provided on the second active pattern AP2. A plurality of second recesses RS2 may be formed on an upper portion of the second active pattern AP2. The second source/drain patterns SD2 may be correspondingly provided in the second recesses RS2. The second source/drain patterns SD2 may be impurity regions of a second conductivity type (e.g., p-type). The second channel pattern CH2 may be interposed between a pair of second source/drain patterns SD2. For example, the pair of second source/drain patterns SD2 may be connected to each other through the stacked first, second, and third semiconductor patterns SP1, SP2, and SP3.

The first and second source/drain patterns SD1 and SD2 may be epitaxial patterns formed by a selective epitaxial growth (SEG) process. For example, each of the first and second source/drain patterns SD1 and SD2 may have a top surface higher than that of the third semiconductor pattern SP3. For another example, at least one of the first and second source/drain patterns SD1 and SD2 may have a top surface at substantially the same level as that of a top surface of the third semiconductor pattern SP3.

In an embodiment, the first source/drain patterns SD1 may include the same semiconductor element (e.g., Si) as that of the substrate 100. The second source/drain patterns SD2 may include a semiconductor element (e.g., SiGe) whose lattice constant is greater than that of a semiconductor element of the substrate 100. Therefore, a pair of second source/drain patterns SD2 may provide the second channel pattern CH2 with compressive stress.

In an embodiment, the second source/drain pattern SD2 may have an uneven embossing shape on a sidewall thereof. For example, the sidewall of the second source/drain pattern SD2 may have a wave-shape profile. The sidewall of the second source/drain pattern SD2 may protrude toward first, second, and third inner electrodes PO1, PO2, and PO3 of a second gate electrode GE2, as will be discussed below. With reference to FIGS. 5Ato 5D, 6A, and 6B, the following will describe in detail the first and second source/drain patterns SD1 and SD2.

A gate electrode GE may include a first gate electrode GE1 and a second gate electrode GE2. The first gate electrode GE1 may be provided on the first channel pattern CH1, and the second gate electrode GE2 may be provided on the second channel pattern CH2. The first gate electrode GE1 may extend in a first direction D1 while running across the first channel pattern CH1, and the second gate electrode GE2 may extend in the first direction D1 while running across the second channel pattern CH2. The first gate electrode GE1 may vertically overlap the first channel pattern CH1, and the second gate electrode GE2 may vertically overlap the second channel pattern CH2. A plurality of first gate electrodes GE1 may be arranged at a first pitch in the second direction D2. Likewise a plurality of second gate electrodes GE2 may be arranged at the first pitch in the second direction D2.

Each of the first and second gate electrodes GE1 and GE2 may include a first inner electrode PO1 interposed between the first semiconductor pattern SP1 and the active pattern AP1 or AP2, a second inner electrode PO2 interposed between the first semiconductor pattern SP1 and the second semiconductor pattern SP2, a third inner electrode PO3 interposed between the second semiconductor pattern SP2 and the third semiconductor pattern SP3, and an outer electrode PO4 on the third semiconductor pattern SP3. With reference to FIGS. 5A, 5B, 6A, and 6B, the following will describe in detail the outer electrode PO4 according to embodiments.

Referring to FIG. 5D, the gate electrode GE may be provided on a top surface TS, a bottom surface BS, and opposite sidewalls SW of each of the first, second, and third semiconductor patterns SP1, SP2, and SP3. For example, a transistor according to the present embodiment may be a three-dimensional field effect transistor (e.g., MBCFET or GAAFET) in which the gate electrode GE three-dimensionally surrounds the first and second channel patterns CH1 and CH2.

On the first active region AR1, inner spacers ISP may be correspondingly interposed between the first source/drain pattern SD1 and the first, second, and third inner electrodes PO1, PO2, and PO3 of the first gate electrode GE1. Each of the first, second, and third inner electrodes PO1, PO2, and PO3 of the first gate electrode GE1 may be spaced apart from the first source/drain pattern SD1 across the inner spacer ISP The inner spacer ISP may prevent a leakage current coming from the first gate electrode GE1.

Referring back to FIGS. 4 and 5A to 5D, a pair of gate spacers GS may be disposed on opposite sidewalls of the outer electrode PO4 of each of the first and second gate electrodes GE1 and GE2. The gate spacers GS may extend in the first direction D1 along the first and second gate electrodes GE1 and GE2. The gate spacers GS may have top surfaces higher than those of the first and second gate electrodes GE1 and GE2. The top surfaces of the gate spacers GS may be coplanar with that of a first interlayer dielectric layer 110, as will be discussed below. In an embodiment, the gate spacers GS may include at least one selected from SiCN, SiCON, and SiN. In another embodiment, the gate spacers GS may include a multiple layer formed of at least two selected from SiCN, SiCON, and SiN. In an embodiment, the gate spacer GS may include a silicon-containing dielectric material. The gate spacer GS may serve as an etch stop layer when active contacts AC1 and AC2 are formed as discussed below. The gate spacer GS may cause the active contacts AC1 and AC2 to form in a self-alignment manner.

A gate capping pattern GP may be provided on each of the first and second gate electrodes GE1 and GE2. The gate capping pattern GP may extend in the first direction D1 along the first and second gate electrodes GE1 and GE2. The gate capping pattern GP may include a material having an etch selectivity with respect to first and second interlayer dielectric layers 110 and 120 which will be discussed below. For example, the gate capping pattern GP may include at least one selected from SiON, SiCN, SiCON, and SiN.

A gate dielectric layer GI may be interposed between the first gate electrode GE1 and the first channel pattern CH1 and between the second gate electrode GE2 and the second channel pattern CH2. The gate dielectric layer GI may cover the top surface TS, the bottom surface BS, and the opposite sidewalls SW of each of the first, second, and third semiconductor patterns SP1, SP2, and SP3. The gate dielectric layer GI may cover a top surface of the device isolation layer ST that underlies the gate electrode GE.

In an embodiment, the gate dielectric layer GI may include a silicon oxide layer and/or a silicon oxynitride layer. Referring to FIGS. 6A and 6B, a high-k dielectric layer HK may be interposed between the gate dielectric layer GI and the first and second gate electrodes GE1 and GE2. The high-k dielectric layer HK may have a uniform thickness to surround the first, second, and third inner electrodes PO1, PO2, and PO3. The high-k dielectric layer HK may uniformly extend from bottom to opposite lateral surfaces of the outer electrode PO4.

The high-k dielectric layer HK of FIG. 6A or 6B may include a high-k dielectric material having a dielectric constant that is greater than that of a silicon oxide layer. For example, the high-k dielectric material may include at least one selected from hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

In another example, the gate dielectric layer GI may have a structure in which at least one of silicon oxide layers and at least one high-k dielectric layer HK are stacked. In another embodiment, a semiconductor device may include a negative capacitance field effect transistor that uses a negative capacitor. For example, the gate dielectric layer GI may include a ferroelectric material layer that exhibits ferroelectric properties and a paraelectric material layer that exhibits paraelectric properties.

The ferroelectric material layer may have a negative capacitance, and the paraelectric material layer may have a positive capacitance. For example, when two or more capacitors are connected in series, and when each capacitor has a positive capacitance, an overall capacitance may be reduced to be less than the capacitance of each capacitor. In contrast, when at least one of two or more capacitors connected in series has a negative capacitance, an overall capacitance may have a positive value that is increased to be greater than an absolute value of the capacitance of each capacitor.

When the ferroelectric material layer having a negative capacitance is connected in series to the paraelectric material layer having a positive capacitance, there may be an increase in overall capacitance of the ferroelectric and paraelectric material layers that are connected in series. The increase in overall capacitance may be used to allow a transistor including the ferroelectric material layer to have a sub-threshold swing of less than about 60 mV/decade at room temperature.

The ferroelectric material layer may have ferroelectric properties. The ferroelectric material layer may include, for example, one or more of hafnium oxide, hafnium zirconium oxide, barium strontium titanium oxide, and lead zirconium titanium oxide. For example, the hafnium zirconium oxide may be a material in which hafnium oxide is doped with zirconium (Zr). As another example, the hafnium zirconium oxide may be a compound of hafnium (Hf), zirconium (Zr), and oxygen (O).

The ferroelectric material layer may further include impurities doped therein. For example, the impurities may include at least one selected from aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of impurities included in the ferroelectric material layer may be changed depending on what ferroelectric material is included in the ferroelectric material layer.

When the ferroelectric material layer includes hafnium oxide, the ferroelectric material layer may include at least one of impurities such as gadolinium (Gd), silicon (Si), zirconium (Zr), aluminum (Al), and yttrium (Y).

When the impurities are aluminum (Al), the ferroelectric material layer may include about 3 to 8 atomic percent aluminum. In this description, the ratio of impurities may be a ratio of aluminum to the sum of hafnium and aluminum.

When the impurities are silicon (Si), the ferroelectric material layer may include about 2 to about 10 atomic percent silicon. When the impurities are yttrium (Y), the ferroelectric material layer may include about 2 to about 10 atomic percent yttrium. When the impurities are gadolinium (Gd), the ferroelectric material layer may include about 1 to about 7 atomic percent gadolinium. When the impurities are zirconium (Zr), the ferroelectric material layer may include about 50 to about 80 atomic percent zirconium.

The paraelectric material layer may have paraelectric properties. The paraelectric material layer may include, for example, at least one selected from silicon oxide and high-k metal oxide. The metal oxide included in the paraelectric material layer may include, for example, one or more of hafnium oxide, zirconium oxide, and aluminum oxide, as non-limiting examples.

The ferroelectric and paraelectric material layers may include the same material. The ferroelectric material layer may have ferroelectric properties, but the paraelectric material layer may not have ferroelectric properties. For example, when the ferroelectric material layer and the paraelectric material layer include hafnium oxide, the hafnium oxide included in the ferroelectric material layer may have a crystal structure different from that of the hafnium oxide included in the paraelectric material layer.

The ferroelectric material layer may have a thickness having ferroelectric properties. The thickness of the ferroelectric material layer may range, for example, from about 0.5 nm to about 10 nm, as non-limiting examples. Because ferroelectric materials have their own critical thickness that exhibits ferroelectric properties, the thickness of the ferroelectric material layer may depend on the ferroelectric material.

As an example, the gate dielectric layer GI may include a single ferroelectric material layer. As another example, the gate dielectric layer GI may include a plurality of ferroelectric material layers that are spaced apart from each other. The gate dielectric layer GI may have a stack structure in which a plurality of ferroelectric material layers are alternately stacked with a plurality of paraelectric material layers.

Referring back to FIGS. 4 and 5A to 5D, the gate electrode GE may include a first metal pattern and a second metal pattern on the first metal pattern. The first metal pattern may be provided on the gate dielectric layer GI and may be adjacent to the first, second, and third semiconductor patterns SP1, SP2, and SP3. The first metal pattern may include a work-function metal that controls a threshold voltage of a transistor. A thickness and composition of the first metal pattern may be adjusted to achieve a desired threshold voltage of a transistor. For example, the first, second, and third inner electrodes PO1, PO2, and PO3 of the gate electrode GE may be formed of a first metal pattern or a work-function metal.

The first metal pattern may include a metal nitride layer. For example, the first metal pattern may include nitrogen (N) and at least one metal selected from titanium (Ti), tantalum (Ta), aluminum (Al), tungsten (W), and molybdenum (Mo). In addition, the first metal pattern may further include carbon (C). The first metal pattern may include a plurality of stacked work-function metal layers.

The second metal pattern may include metal having a resistance that is less than that of the first metal pattern. For example, the second metal pattern may include at least one metal selected from tungsten (W), aluminum (Al), titanium (Ti), and tantalum (Ta). The outer electrode PO4 of each of the first and second gate electrodes GE1 and GE2 may include a first metal pattern and a second metal pattern on the first metal pattern.

A first interlayer dielectric layer 110 may be provided on the substrate 100. The first interlayer dielectric layer 110 may cover the gate spacers GS and the first and second source/drain patterns SD1 and SD2. The first interlayer dielectric layer 110 may have a top surface that is substantially coplanar with the top surface of the gate capping pattern GP and the top surface of the gate spacer GS. The first interlayer dielectric layer 110 may be provided thereon with a second interlayer dielectric layer 120 that covers the gate capping pattern GP. A third interlayer dielectric layer 130 may be provided on the second interlayer dielectric layer 120. A fourth interlayer dielectric layer 140 may be provided on the third interlayer dielectric layer 130. For example, the first to fourth interlayer dielectric layers 110 to 140 may include a silicon oxide layer.

The single height cell SHC may have a first boundary BD1 and a second boundary BD2 that are opposite to each other in the second direction D2. The first and second boundaries BD1 and BD2 may extend in the first direction D1. The single height cell SHC may have a third boundary BD3 and a fourth boundary BD4 that are opposite to each other in the first direction D1. The third and fourth boundaries BD3 and BD4 may extend in the second direction D2.

The single height cell SHC may be provided on its opposite sides with a pair of separation structures DB that are opposite to each other in the second direction D2. For example, the pair of separation structures DB may be correspondingly provided on first and second boundaries BD1 and BD2 of the single height cell SHC. The separation structure DB may extend in the first direction D1 parallel to the gate electrodes GE. A pitch between the separation structure DB and its adjacent gate electrode GE may be the same as the first pitch.

The separation structure DB may penetrate the first and second interlayer dielectric layers 110 and 120 to extend into the first and second active patterns AP1 and AP2. The separation structure DB may penetrate an upper portion of each of the first and second active patterns AP1 and AP2. The separation structure DB may electrically separate an active region of the single height cell SHC from an active region of an adjacent another cell.

First and second active contacts AC1 and AC2 may be provided to penetrate the first and second interlayer dielectric layers 110 and 120 to come into electrical connection with the first and second source/drain patterns SD1 and SD2, respectively. A pair of active contacts AC1 and AC2 may be provided on opposite sides of the gate electrode GE. When viewed in a plan view, each of the first and second active contacts AC1 and AC2 may have a bar shape that extends in the first direction D1.

The first and second active contacts AC1 and AC2 may each be a self-aligned contact. For example, the gate capping pattern GP and the gate spacer GS may be used to form the first and second active contacts AC1 and AC2 in a self-alignment manner. For example, the first and second active contacts AC1 and AC2 may each cover at least a portion of a sidewall of the gate spacer GS. Although not shown, the first and second active contacts AC1 and AC2 may cover a portion of the top surface of the gate capping pattern GP.

A metal-semiconductor compound layer SC, such as a silicide layer, may be interposed between the first active contact AC1 and the first source/drain pattern SD1 and between the second active contact AC2 and the second source/drain pattern SD2. The first and second active contact AC1 and AC2 may be electrically connected through the metal-semiconductor compound layers SC to the first and second source/drain patterns SD1 and SD2. For example, the metal-semiconductor compound layer SC may include at least one selected from titanium silicide, tantalum silicide, tungsten silicide, nickel silicide, and cobalt silicide.

Gate contacts GC may be provided to penetrate the second interlayer dielectric layer 120 and the gate capping pattern GP to come into electrical connection with corresponding gate electrodes GE. When viewed in a plan view, the gate contacts GC may be disposed to correspondingly overlap the first active region AR1 and the second active region AR2. For example, the gate contact GC may be provided on the second active pattern AP2 (see FIG. 5B).

In an embodiment, referring to FIG. 5B, the gate contact GC may have an upper portion adjacent to the gate contact GC. The upper portion of the gate contact GC may be filled with an upper dielectric pattern UIP. The upper dielectric pattern UIP may have a bottom surface lower than that of the gate contact GC. For example, the upper dielectric pattern UIP may cause the second active contact AC2 adjacent to the gate contact GC to have a top surface lower than the bottom surface of the gate contact GC. Therefore, it may be possible to prevent an electrical short that might be caused by contact between the gate contact GC and its adjacent second active contact AC2.

The first active contact AC1 may include a first conductive pattern FM1 and a first barrier pattern BM1 that surrounds the first conductive pattern FM1. The second active contact AC2 may include a second conductive pattern FM2 and a second barrier pattern BM2 that surrounds the second conductive pattern FM2. The gate contact GC may include a conductive pattern FM and a barrier pattern BM that surrounds the conductive pattern FM. For example, the conductive patterns FM1, FM2, and FM may each include at least one selected from aluminum, copper, tungsten, molybdenum, and cobalt. The barrier patterns BM1, BM2, and BM may cover sidewalls and bottom surfaces of the conductive patterns FM1, FM2, and FM, respectively. The barrier patterns BM1, BM2, and BM may each include a metal layer and a metal nitride layer. The metal layer may include at least one selected from titanium, tantalum, tungsten, nickel, cobalt, and platinum. The metal nitride layer may include at least one selected from a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer.

A first metal layer M1 may be provided in the third interlayer dielectric layer 130. For example, the first metal layer M1 may include a first power line M1_R1, a second power line M1_R2, and first wiring lines M1_I. The lines M1_R1, M1_R2, and M1_I of the first metal layer M1 may extend in parallel to each other in the second direction D2.

For example, the first and second power lines M1_R1 and M1_R2 may be respectively provided on the third and fourth boundaries BD3 and BD4 of the single height cell SHC. The first power line M1_R1 may extend in the second direction D2 along the third boundary BD3. The second power line M1_R2 may extend in the second direction D2 along the fourth boundary BD4.

The first wiring lines M1_I of the first metal layer M1 may be disposed between the first and second power lines M1_R1 and M1_R2. The first wiring lines M1_I of the first metal layer M1 may be arranged at a second pitch along the first direction D1. The second pitch may be less than the first pitch. Each of the first wiring lines M1_I may have a line-width less than that of each of the first and second power lines M1_R1 and M1_R2.

The first metal layer M1 may further include first vias VI1. The first vias VI1 may be correspondingly provided below the lines M1_R1, M1_R2, and M1_I of the first metal layer M1. The first via VI1 may electrically connect the active contact AC1 or AC2 to one of the lines M1_R1, M1_R2, M1_R3, and M1_I of the first metal layer M1. The first via VI1 may electrically connect the gate contact GC to one of the lines M1_R1, M1_R2, and M1_I of the first metal layer M1.

A certain line and its underlying first via VI1 of the first metal layer M1 may be formed by individual processes. For example, the certain line and its underlying first via VI1 of the first metal layer M1 may each be formed by a single damascene process. A sub-20 nm process may be employed to fabricate a semiconductor device according to some embodiments.

A second metal layer M2 may be provided in the fourth interlayer dielectric layer 140. The second metal layer M2 may include a plurality of second wiring lines M2_I. The second wiring lines M2_I of the second metal layer M2 may each have a linear or bar shape that extends in the first direction D1. For example, the second lines M2_I may extend in parallel to each other in the first direction D1.

The second metal layer M2 may further include second vias VI2 that are correspondingly provided below the second wiring lines M2_I. A certain line of the first metal layer M1 may be connected electrically through the second via VI2 to a corresponding line of the second metal layer M2. For example, a wiring line and its underlying second via VI2 of the second metal layer M2 may be simultaneously formed in a dual damascene process.

The first and second metal layers M1 and M2 may have wiring lines that include the same or different conductive materials. For example, the wiring lines of the first and second metal layers M1 and M2 may include at least one metallic material selected from aluminum, copper, tungsten, molybdenum, ruthenium, and cobalt. Although not shown, other metal layers (e.g., M3, M4, M5, etc.) may be additionally stacked on the fourth interlayer dielectric layer 140. Each of the stacked metal layers may include wiring lines for routing between cells.

With reference to FIGS. 5A to 5D, 6A, and 6B, the following will describe in detail the first and second source/drain patterns SD1 and SD2, the outer electrode PO4 of the second gate electrode GE2, the gate dielectric layer GI, and the first and second active contact AC1 and AC2. The first source/drain pattern SD1 may have a first height HE1 in the third direction. The first height HE1 may be defined to indicate a length from bottom to top surfaces of the first source/drain pattern SD1. The second source/drain pattern SD2 may have a second height HE2 in the third direction. The second height HE2 may be defined to indicate a length from bottom to top surfaces of the second source/drain pattern SD2. The first height HE1 may be less than the second height HE2. A difference between the first height HE1 and the second height HE2 may be the same as a height in the third direction of a lower portion GDP, which will be discussed below, of the outer electrode PO4 included in the second gate electrode GE2.

Referring to FIG. 6B, the outer electrode PO4 of the second gate electrode GE2 may include a lower portion GDP and an upper portion GUP on the lower portion GDP. The lower portion GDP may extend toward the second source/drain pattern SD2. The upper portion GUP may vertically overlap the lower portion GDP. For example, the lower portion GDP may have a first width WD in the second direction, and the upper portion GUP may have a second width WU in the second direction. The first width WD may be greater than the second width WLJ. In addition, the first width WD may be greater than a width in the second direction of each of the first, second, and third inner electrodes PO1, PO2, and PO3 included in the second gate electrode GE2. The outer electrode PO4 may have at its lower portion a thickness different from that of each of the first, second, and third inner electrodes PO1, PO2, and PO3. The outer electrode PO4 may have a cross-section of an inverted T shape, as illustrated in FIGs. 5B and 6B for example.

Referring back to FIG. 6B, the gate dielectric layer GI may include an inner gate dielectric layer IIL adjacent to the first, second, and third inner electrodes PO1, PO2, and PO3, and may also include an outer gate dielectric layer OIL adjacent to the outer electrode PO4. The inner gate dielectric layer IIL may be provided on the first, second, and third inner electrodes PO1, PO2, and PO3. For example, the inner gate dielectric layer III, may surround the first, second, and third inner electrodes PO1, PO2, and PO3.

The outer gate dielectric layer OIL may be provided on the outer electrode PO4 of the second gate electrode GE2. The outer gate dielectric layer OIL may be provided on bottom and lateral surfaces of the outer electrode PO4, and may extend to the gate capping pattern (see GP of FIG. 5B) that covers a top surface of the outer electrode PO4. For example, the outer gate dielectric layer OIL may extend from bottom to lateral surfaces of the lower portion GDP of the outer electrode PO4, and further extend to a lateral surface of the upper portion GUP of the outer electrode PO4. A lateral surface of the outer gate dielectric layer OIL adjacent to the lower portion GDP of the outer electrode PO4 may be in direct contact with the second source/drain pattern SD2. The outer gate dielectric layer OIL and the outer electrode PO4 may together have cross-section of an inverted T shape.

The high-k dielectric layer HK may be interposed between the inner gate dielectric layer IIL and the first, second, and third inner electrodes PO1, PO2, and PO3, and may also be interposed between the outer electrode PO4 and the outer gate dielectric layer OIL. For example, the high-k dielectric layer HK may be provided on the first, second, and third inner electrodes PO1, PO2, and PO3, and the inner gate dielectric layer IIL may be provided on the high-k dielectric layer HK. The high-k dielectric layer HK may be provided on the outer electrode PO4, and the outer gate dielectric layer OIL may be provided on the high-k dielectric layer HK. The high-k dielectric layer HK may surround the first, second, and third inner electrodes PO1, PO2, and PO3. The high-k dielectric layer HK may be formed to have a uniform thickness.

The first active contact AC1 may include a first conductive pattern FM1 and a first barrier pattern BM1 that surrounds the first conductive pattern FM1. The first active contact AC1 may vertically overlap the first source/drain pattern SD1. The first active contact AC1 may be electrically connected to the first source/drain pattern SD1. For example, the first active contact AC1 may have a lower portion that is inserted onto the first source/drain pattern SD1. The lower portion of the first active contact AC1 and the first source/drain pattern SD1 may contact each other through a recess region.

A silicide layer SC may be interposed between the first active contact AC1 and the first source/drain pattern SD1. The silicide layer SC may be a metal-semiconductor compound layer. The silicide layer SC may reduce a contact resistance between the first active contact AC1 and the first source/drain pattern SD1. For example, the first active contact AC1 may be electrically connected through the silicide layer SC to the first source/drain pattern SD1.

Referring to FIG. 6A, the first source/drain pattern SD1 may have a recess region formed by performing an etching process. The first active contact AC1 may be inserted through the recess region into the first source/drain pattern SD1. The inserted first active contact AC1 may define a first recess depth RSD1 of the first source/drain pattern SD1. For example, the first recess depth RSD1 may be defined to indicate a depth to which the first active contact AC1 is recessed into the first source/drain pattern SD1. The first recess depth RSD1 may be defined to indicate a vertical length from the top surface of the first source/drain pattern SD1 to a bottom surface of the first active contact AC1. The bottom surface of the first active contact AC1 may correspond to the bottom surface of the first barrier pattern BM1. The first barrier pattern BM1 may cover lateral and bottom surfaces of the first conductive pattern FM1. The bottom surface and a portion of a lateral surface of the first barrier pattern BM1 may be in contact with the silicide layer SC.

Referring to FIG. 6B, the second active contact AC2 may include a second conductive pattern FM2 and a second barrier pattern BM2 that surrounds the second conductive pattern FM2. The second active contact AC2 may vertically overlap the second source/drain pattern SD2. The second active contact AC2 may be electrically connected to the second source/drain pattern SD2. For example, the second active contact AC2 may have a lower portion that is inserted into the second source/drain pattern SD2. The lower portion of the second active contact AC2 and the second source/drain pattern SD2 may be in contact with each other through a recess region.

A silicide layer SC may be interposed between the second active contact AC2 and the second source/drain pattern SD2. The silicide layer SC may be a metal-semiconductor compound layer. The silicide layer SC may reduce a contact resistance between the second active contact AC2 and the second source/drain pattern SD2. For example, the second active contact AC2 may be electrically connected through the silicide layer SC to the second source/drain pattern SD2.

Referring to FIG. 6B, the second source/drain pattern SD2 may have a recess region formed by performing an etching process. The second active contact AC2 may be inserted through the recess region into the second source/drain pattern SD2. The recessed second active contact AC2 may define a second recess depth RSD2 of the second source/drain pattern SD2. For example, the second recess depth RSD2 may be defined to indicate a depth to which the second active contact AC2 is inserted into the second source/drain pattern SD2. For example, the second recess depth RSD2 may be defined to indicate a vertical length from the top surface of the second source/drain pattern SD2 to a bottom surface of the second active contact AC2. The bottom surface of the second active contact AC2 may correspond to that of the second barrier pattern BM2. The second barrier pattern BM2 may cover lateral and bottom surfaces of the second conductive pattern FM2. The bottom surface and a portion of a lateral surface of the second barrier pattern BM2 may be in contact with the silicide layer SC.

Referring to FIGS. 6A and 6B, the first recess depth RSD1 may be greater than the second recess depth RSD2. The first recess depth RSD1 may be about 1.2 times to about 2.5 times the second recess depth RSD2. For example, the first recess depth RSD1 may be about 1.5 times to about 2 times the second recess depth RSD2. In more detail, the first recess depth RSD1 may range from about 10.0 nm to about 12.0 nm. The second recess depth RSD2 may range from about 5.0 nm to about 7.0 nm.

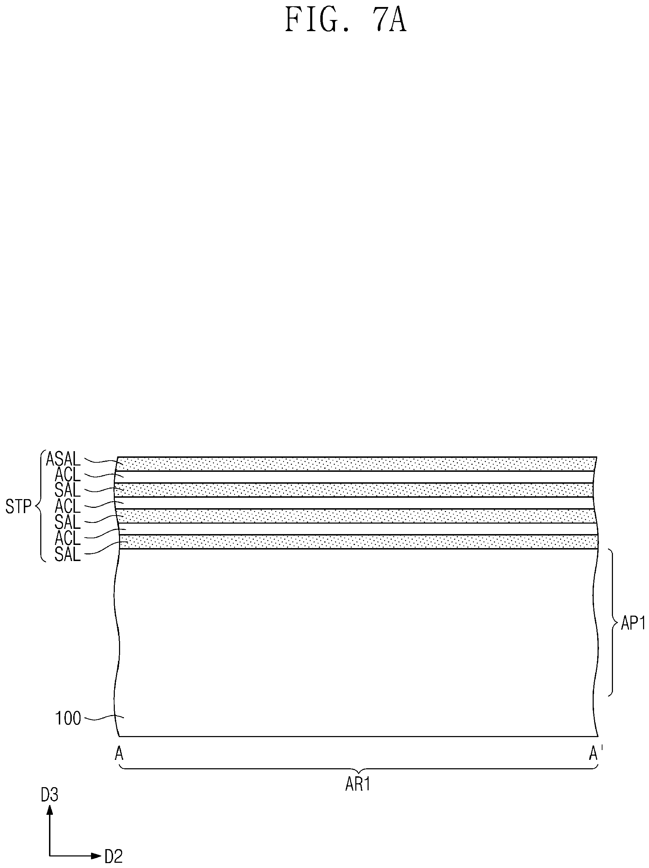

A subsequently described additional sacrificial layer (see ASAL of FIG. 7A) may be used to adjust the first and second recess depths RSD1 and RSD2 to their target values. For example, the first recess depth RSD1 of the first source/drain pattern SD1 provided on an NMOSFET region may be adjusted to be greater than the second recess depth RSD2 of the second source/drain pattern SD2 provided on a PMOSFET region. In addition, the additional sacrificial layer ASAL may cause the second source/drain pattern SD2 to have the second height HE2 greater than the first height HE1 of the first source/drain pattern SD1. For example, a difference between the second height HE2 and the first height HE1 may be the same as a thickness of the additional sacrificial layer ASAL.

Referring back to FIGS. 5A to 5C, the bottom surface of the first active contact AC1 may be lower than that of the third semiconductor pattern SP3 included in the first channel pattern CH1, relative to a bottom of the substrate 100. The bottom surface of the first active contact AC1 may correspond to that of the first barrier pattern BM1, and thus the bottom surface of the first barrier pattern BM1 may be lower than that of the third semiconductor pattern SP3. A first level LV1 may be defined to indicate a position level in the third direction D3 of the bottom surface of the third semiconductor pattern SP3 included in the first channel pattern CH1. A second level LV2 may be defined to indicate a position level in the third direction D3 of the bottom surface of the first active contact AC1. The second level LV2 may be lower than the first level LV1. For example, the second level LV2 may be located lower in the third direction D3 than the first level LV1.

The bottom surface of the second active contact AC2 may be higher than a top surface of the third semiconductor pattern SP3 included in the second channel pattern CH2, relative to a bottom of the substrate. The bottom surface of the second active contact AC2 may correspond to that of the second barrier pattern BM2, and thus the bottom surface of the second barrier pattern BM2 may be higher than the top surface of the third semiconductor pattern SP3. In addition, the bottom surface of the second active contact AC2 may be higher than the top surface of the third semiconductor pattern SP3 and lower than an upper portion of the outer electrode PO4. For example, the bottom surface of the second active contact AC2 may be located at a level between the lower portions GDP of the outer electrodes PO4.

A third level LV3 may be defined to indicate a position level in the third direction D3 of a bottom surface of the third semiconductor pattern SP3 included in the second channel pattern CH2. The third level LV3 may be the same as the first level LV1 of FIG. 5A. A fourth level LV4 may be defined to indicate a position level in the third direction D3 of the bottom surface of the second active contact AC2. The fourth level LV4 may be higher than the third level LV3. For example, the fourth level LV4 may be located higher in the third direction D3 than the third level LV3. A fifth level LV5 may be defined to indicate a position level in the third direction D3 of the top surface of the third semiconductor pattern SP3 included in the second channel pattern CH2. The fourth level LV4 may be located higher in the third direction D3 than the fifth level LV5.

Referring back to FIG. 5C, the second level LV2 may be lower than the fourth level LV4. In this configuration, the bottom surface of the first active contact AC1 may be lower than that of the second active contact AC2. For example, the bottom surface of the first barrier pattern BM1 of the first active contact AC1 may be lower than that of the second barrier pattern BM2 of the second active contact AC2. This difference in the location of the bottom surface of the first barrier pattern BM1 and the location of the bottom surface of the second barrier pattern BM2 may be caused by the fact that the first recess depth RSD1 of FIG. 6A is greater than the second recess depth RSD2 of FIG. 6B.

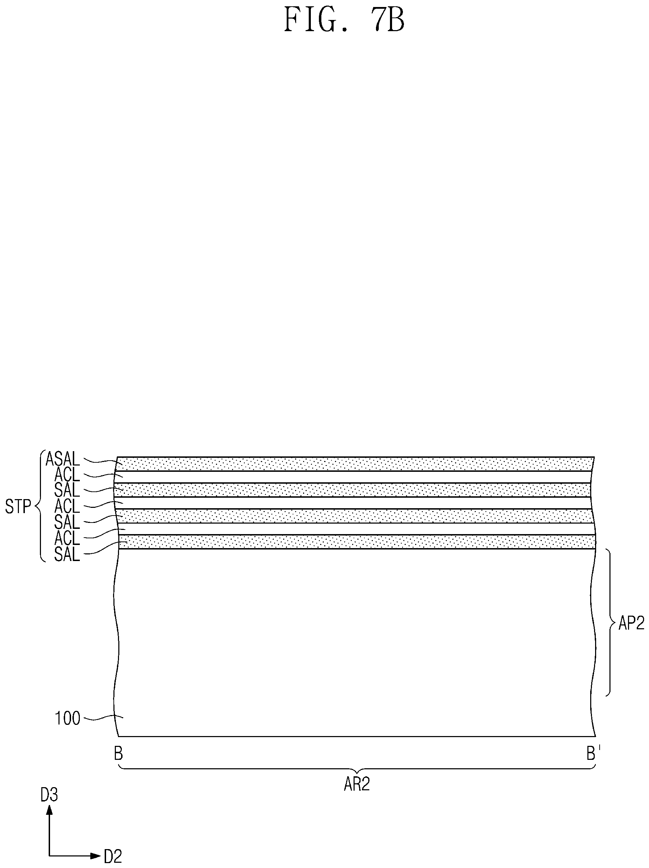

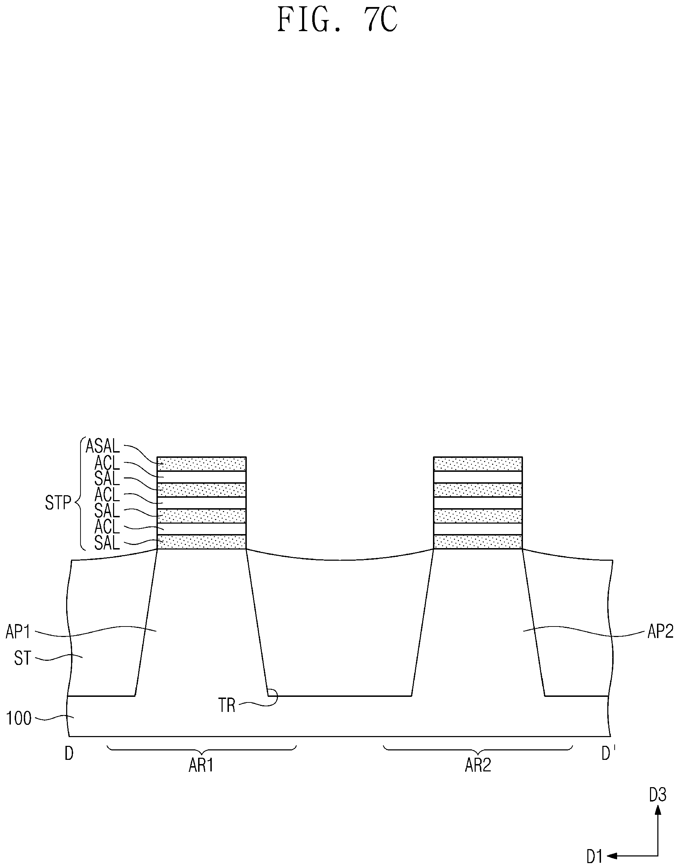

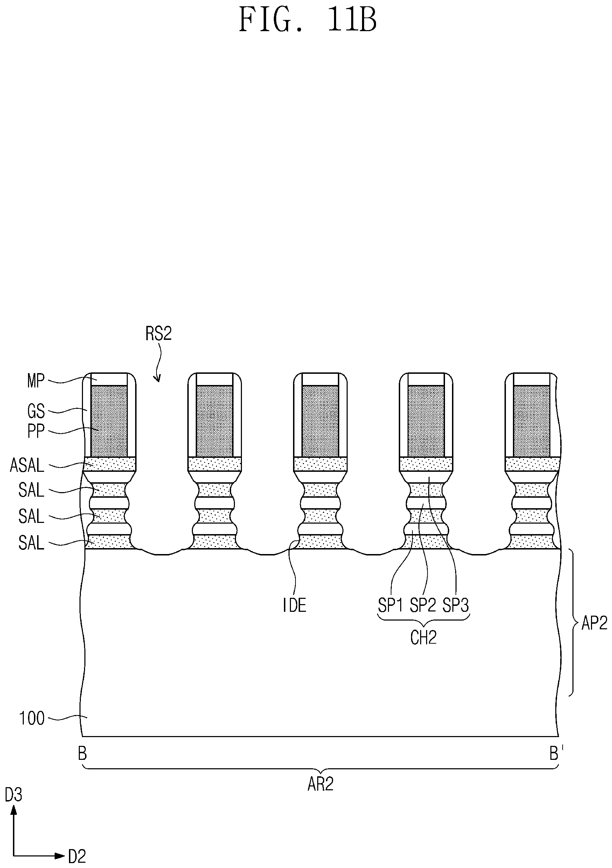

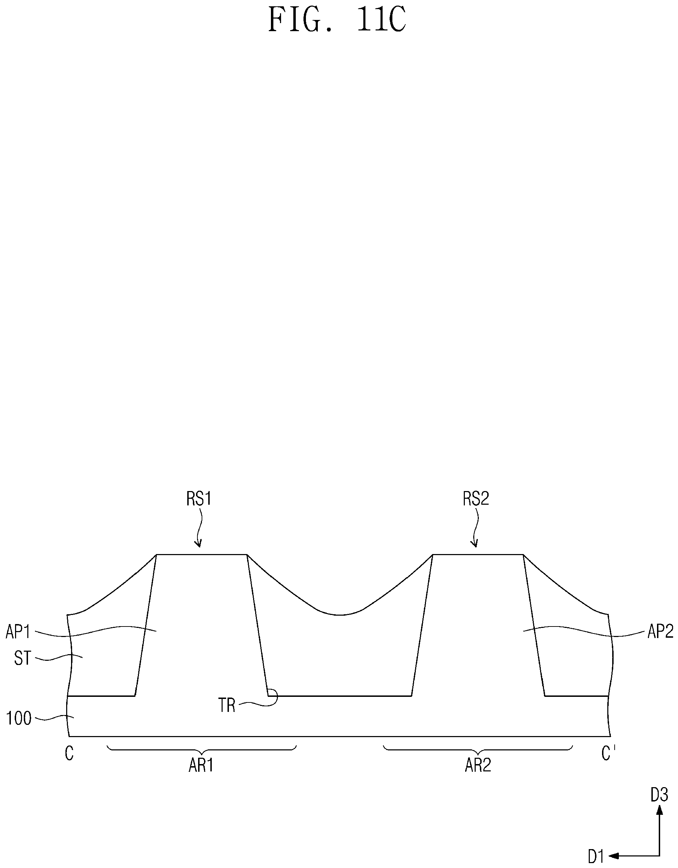

FIGS. 7A to 15D illustrate cross-sectional views showing a method of fabricating a semiconductor device according to some embodiments. FIGS. 7A, 8A, 9A, 10A, 11A, 12A, 13A, 14A, and 15A illustrate cross-sectional views taken along line A-A' of FIG. 4. FIGS. 7B, 8B, 9B, 10B, 11B, 12B, 13B, 14B, and 15B illustrate cross-sectional views taken along line B-B' of FIG. 4. FIGS. 11C, 12C, 13C, 14C, and 15C illustrate cross-sectional views taken along line C-C' of FIG. 4. FIGS. 7C, 8C, 9C, 10C, 13D, 14D, and 15D illustrate cross-sectional views taken along line D-D' of FIG. 4.

Referring to FIGS. 7Ato 7C, a substrate 100 may be provided to include a first active region AR1 and a second active region AR2. Active layers ACL and sacrificial layers SAL may be alternately stacked on the substrate 100. The active layers ACL may include one of silicon (Si), germanium (Ge), and silicon-germanium (SiGe), and the sacrificial layers SAL may include another of silicon (Si), germanium (Ge), and silicon-germanium (SiGe). An additional sacrificial layer ASAL may be defined to indicate an uppermost one of the sacrificial layers SAL alternately stacked. The additional sacrificial layer ASAL may include another of silicon (Si), germanium (Ge), and silicon-germanium (SiGe).

The sacrificial layer SAL and the additional sacrificial layer ASAL may include a material having an etch selectivity with respect to the active layer ACL. For example, the active layers ACL may include silicon (Si), and the sacrificial layer SAL and the additional sacrificial layer ASAL may include silicon-germanium (SiGe). Each of the sacrificial layers SAL and the additional sacrificial layer ASAL may have a germanium concentration of about 10 at% to about 30 at%.

Mask patterns may be formed on each of the first and second active regions AR1 and AR2 of the substrate 100. The mask pattern may have a linear or bar shape that extends in a second direction D2.

A patterning process may be performed in which the mask patterns are used as an etching mask to form a trench TR that defines a first active pattern AP1 and a second active pattern AP2. The first active pattern AP1 may be formed on the first active region AR1.The second active pattern AP2 may be formed on the second active region AR2.

A stack pattern STP may be formed on each of the first and second active patterns AP1 and AP2. The stack pattern STP may include the active layers ACL and the sacrificial layers SAL that are alternately stacked. The additional sacrificial layer ASAL may be positioned at top of the stack pattern STP During the patterning process, the stack pattern STP may be formed together with the first and second active patterns AP1 and AP2.

A device isolation layer ST may be formed to fill the trench TR. For example, a dielectric layer may be formed on an entire surface of the substrate 100 to cover the stack patterns STP and the first and second active patterns AP1 and AP2. The dielectric layer may be recessed until the stack patterns STP are exposed, and thus the device isolation layer ST may be formed.

The device isolation layer ST may include a dielectric material, such as a silicon oxide layer. The stack patterns STP may be exposed upwards from the device isolation layer ST. For example, the stack patterns STP may vertically protrude upwards from the device isolation layer ST.

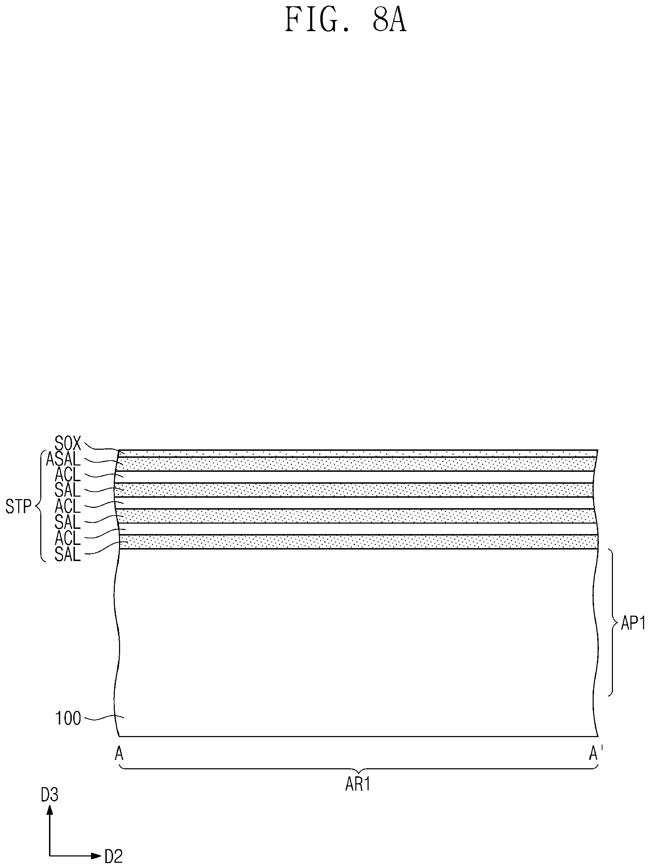

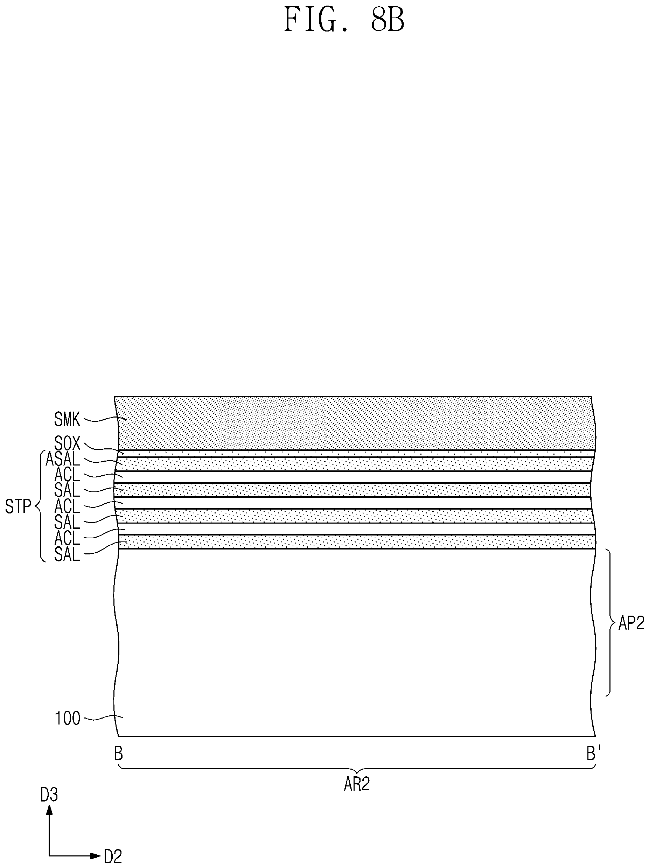

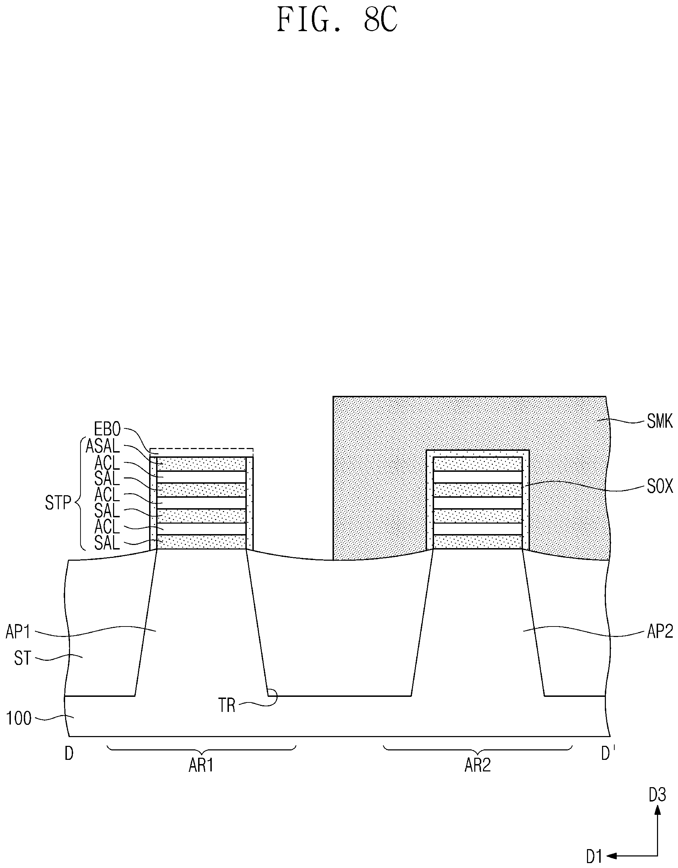

Referring to FIGS. 8A to 8C, a sacrificial oxide layer SOX may be formed on the stack patterns STP and the device isolation layer ST. The sacrificial oxide layer SOX may be formed by performing a radical oxidation process that uses an oxygen radical or a hydrogen radical. For example, the sacrificial oxide layer SOX may be a dielectric layer that covers the device isolation layer ST and also covers top and opposite lateral surfaces of the stack patterns STP. The sacrificial oxide layer SOX may be formed uniformly on the device isolation layer ST and the stack patterns STP

A softmask pattern SMK may be formed on the second active region AR2. The softmask pattern SMK may have a linear or bar shape that extends in the second direction D2.

A patterning process may be performed in which the softmask pattern SMK is used as an etching mask to pattern the sacrificial oxide layer SOX formed on the first active region AR1. For example, the sacrificial oxide layer SOX on the device isolation layer ST may be etched to expose the device isolation layer ST. In addition, an exposure region EBO may be formed by etching the sacrificial oxide layer SOX on a top surface of the stack pattern STP on the first active region AR1. For example, the exposure region EBO may expose the top surface of the stack pattern STP The sacrificial oxide layer SOX may remain on opposite lateral surfaces of the stack pattern STP.

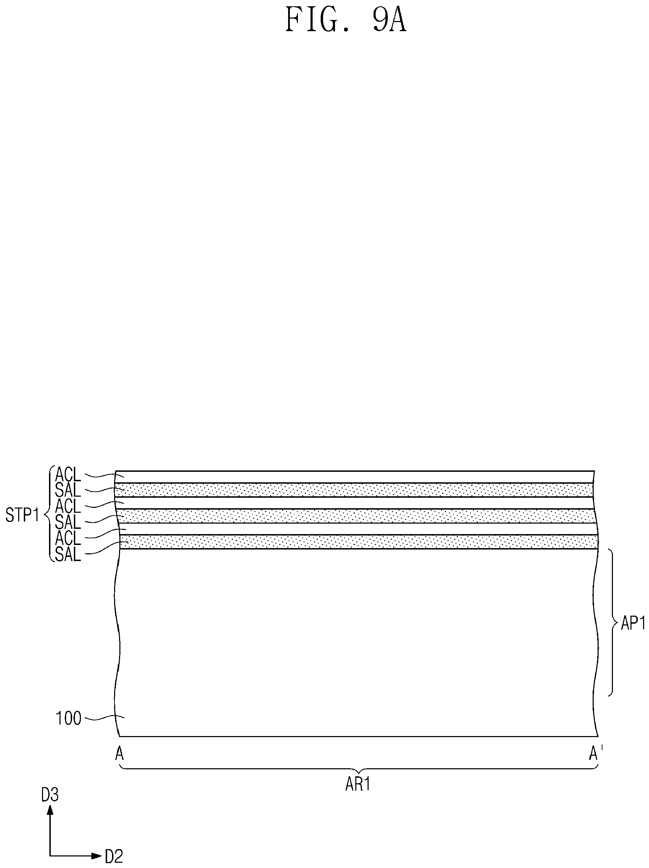

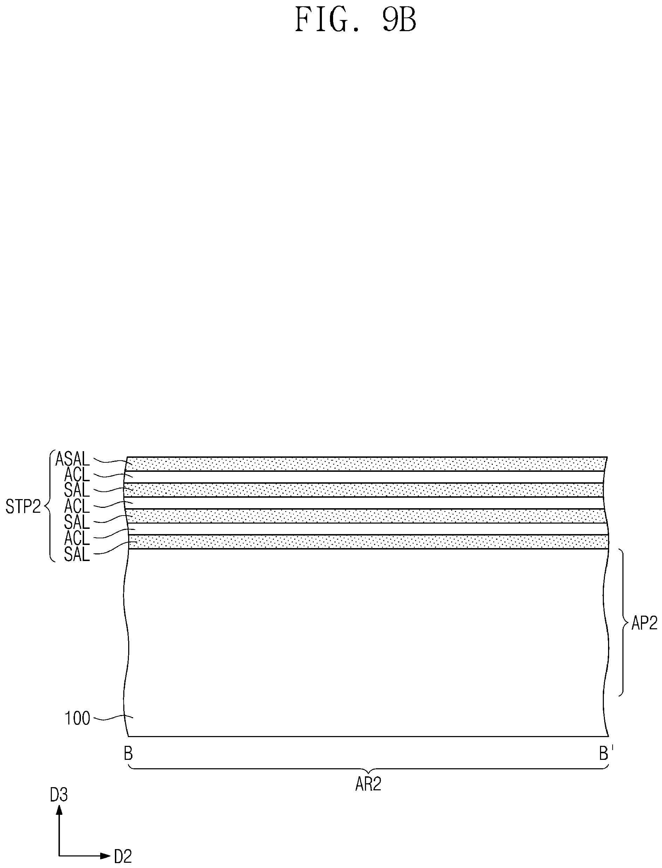

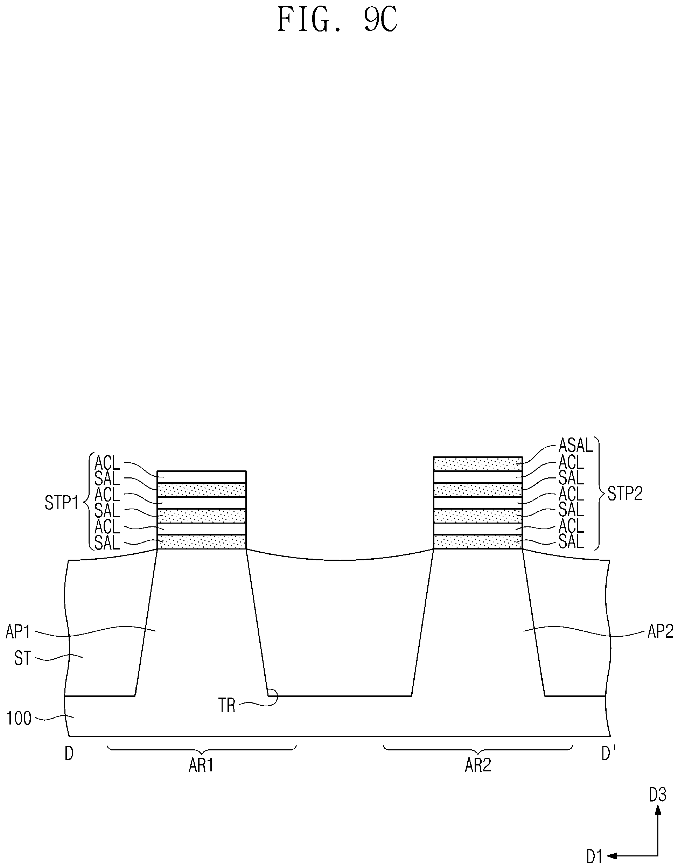

Referring to FIGS. 9A to 9C, a first stack pattern STP1 may be formed on the first active pattern AP1, and a second stack pattern STP2 may be formed on the second active pattern AP2. An ashing or strip process may be performed to remove the sacrificial oxide layer SOX and the softmask pattern SMK on the second active region AR2. A plasma may be used to perform the ashing process. A wet chemical procedure may be used to perform the strip process.

The first stack pattern STP1 may include the active layers ACL and the sacrificial layers SAL that are alternately stacked. The additional sacrificial layer ASAL of the first stack pattern STP1 may be removed through the exposure region EBO when the ashing or strip process is performed. For example, the active layer ACL may be provided at top of the first stack pattern STP1.

The second stack pattern STP2 may include the active layers ACL and the sacrificial layers SAL that are alternately stacked. The additional sacrificial layer ASAL may be provided at top of the second stack pattern STP2. Because no exposure region is present on the second stack pattern STP2, the additional sacrificial layer ASAL may remain on the second stack pattern STP2.

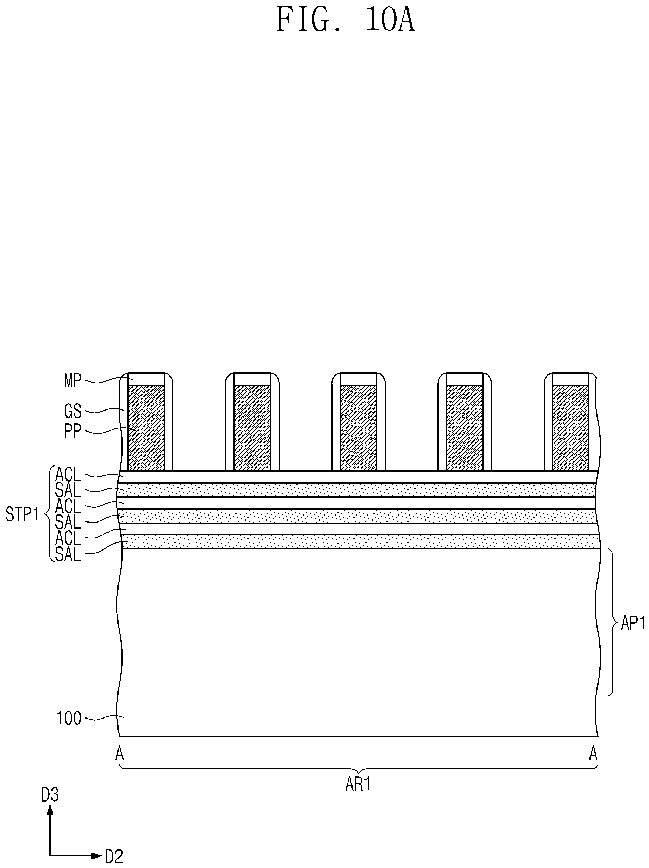

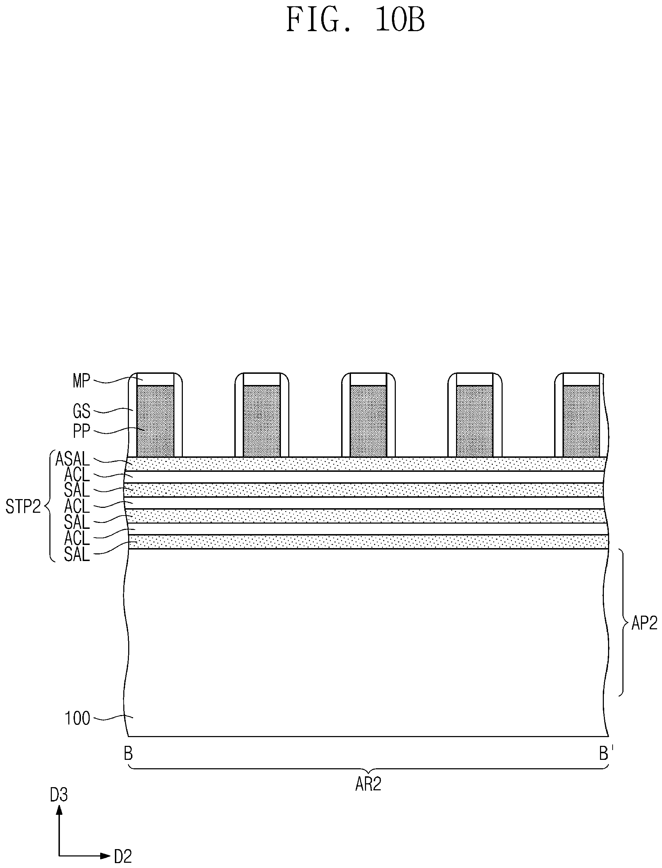

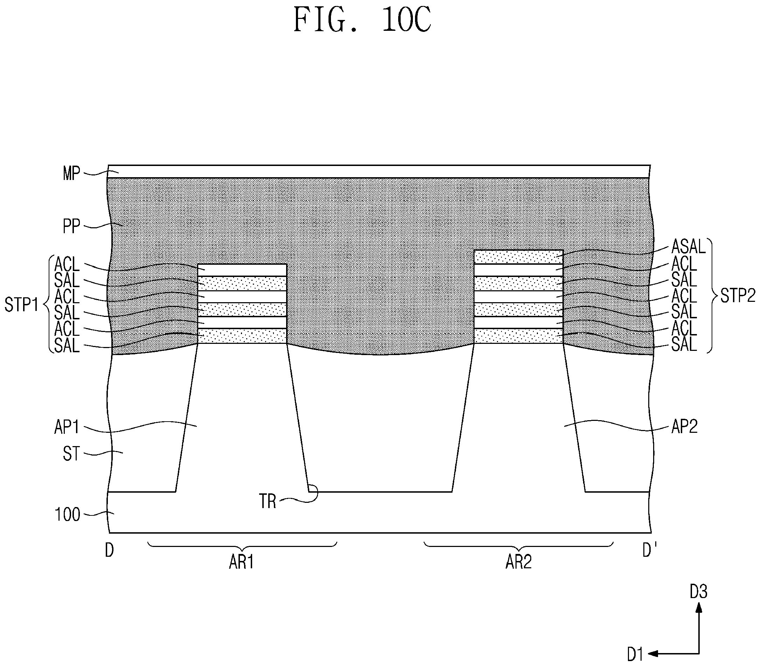

Referring to FIGS. 10A to 10C, sacrificial patterns PP may be formed on the substrate 100, running across the first and second stack patterns STP1 and STP2. Each of the sacrificial patterns PP may be formed to have a linear or bar shape that extends in a first direction D1. The sacrificial patterns PP may be arranged at a first pitch along the second direction D2.

For example, the formation of the sacrificial patterns PP may include forming a sacrificial layer on the entire surface of the substrate 100, forming hardmask patterns MP on the sacrificial layer, and using the hardmask patterns MP as an etching mask to pattern the sacrificial layer. The sacrificial layer may include polysilicon.

A pair of gate spacers GS may be formed on opposite sidewalls of each of the sacrificial patterns PP. The formation of the gate spacers GS may include conformally forming a gate spacer layer on the entire surface of the substrate 100 and anisotropically etching the gate spacer layer. In an embodiment, the gate spacer GS may be a multiple layer including at least two layers.

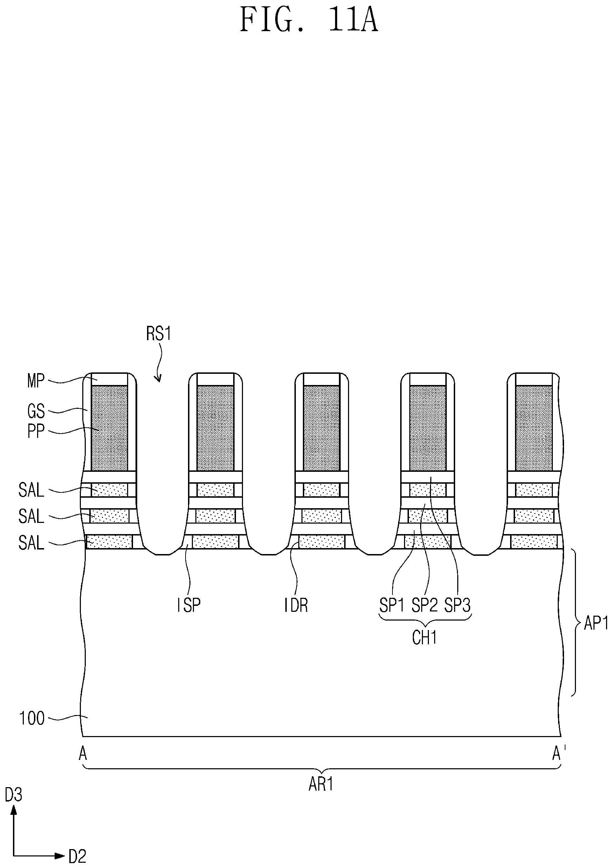

Referring to FIGS. 11A to 11C, first recesses RS1 may be formed in the first stack pattern STP1 on the first active pattern AP1. Second recesses RS2 may be formed in the second stack pattern STP2 on the second active pattern AP2. During the formation of the first and second recesses RS1 and RS2, the device isolation layer ST may be further recessed on opposite sides of each of the first and second active patterns AP1 and AP2 (see FIG. 11C).

For example, the hardmask patterns MP and the gate spacers GS may be used as an etching mask to etch the first stack pattern STP1 on the first active pattern AP1, which may result in the formation of the first recesses RS1. The first recess RS1 may be formed between a pair of sacrificial patterns PP.

The active layers ACL may be formed into first, second, and third semiconductor patterns SP1, SP2, and SP3 that are sequentially stacked between neighboring first recesses RS1. A first channel pattern CH1 may be constituted by the first, second, and third semiconductor patterns SP1, SP2, and SP3 between neighboring first recesses RS1.

The first recess RS1 may be formed between neighboring sacrificial patterns PP. A width in the second direction D2 of the first recess RS1 may decrease with decreasing distance from the substrate 100.

The first recess RS1 may expose the sacrificial layers SAL. A selective etching process may be performed on the exposed sacrificial layers SAL. The etching process may include a wet etching process that selectively etches silicon-germanium. In the etching process, each of the sacrificial layers SAL may be indented to form an indent region IDR. The indent region IDR may allow the sacrificial layer SAL to have a concave sidewall. A dielectric layer may be formed in the first recess RS1, filling the indent regions IDR. The sacrificial layers SAL and the first, second, and third semiconductor patterns SP1, SP2, and SP3 exposed by the first recess RS1 may become a seed layer for the dielectric layer. The dielectric layer may be a crystalline dielectric layer grown on a crystalline semiconductor included in the sacrificial layers SAL and the first, second, and third semiconductor patterns SP1, SP2, and SP3.

An inner spacer ISP may be formed to fill the indent region IDR. For example, the formation of the inner spacer ISP may include wet-etching an epitaxial dielectric layer until sidewalls of the first, second, and third semiconductor patterns SP1, SP2, and SP3 are exposed. Therefore, the epitaxial dielectric layer may remain only in the indent region IDR, thereby constituting the inner spacer ISP.

Referring back to FIGS. 11A to 11C, the second recesses RS2 in the second stack pattern STP2 on the second active pattern AP2 may be formed by a method similar to that used for forming the first recesses RS1. The sacrificial layers SAL and the additional sacrificial layer ASAL exposed by the second recess RS2 may undergo a selective etching process to form indent regions IDE on the second active pattern AP2. The indent regions IDE may cause the second recess RS2 to have a wave-shape inner sidewall. The inner spacers ISP may not be formed in the indent regions IDE on the second active pattern AP2. A second channel pattern CH2 may be constituted by the first, second, and third semiconductor patterns SP1, SP2, and SP3 between neighboring second recesses RS2.

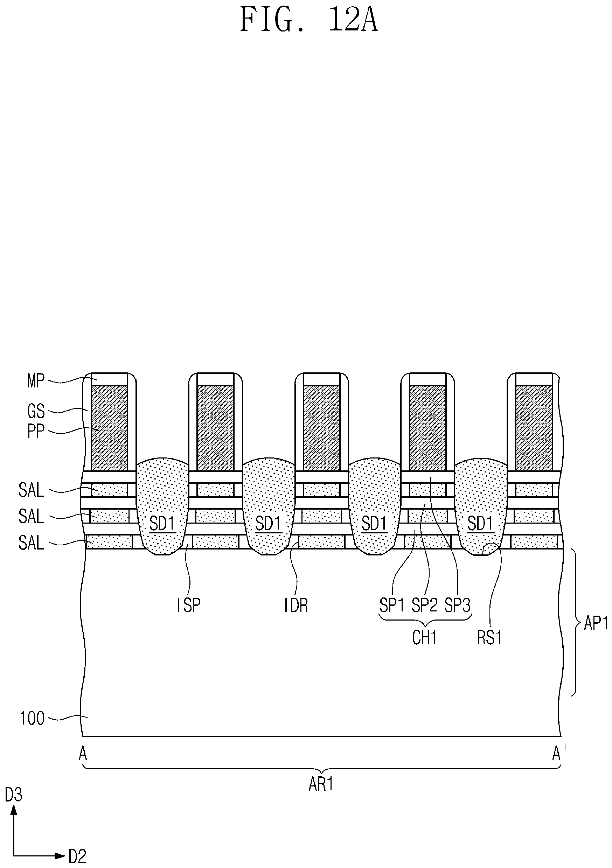

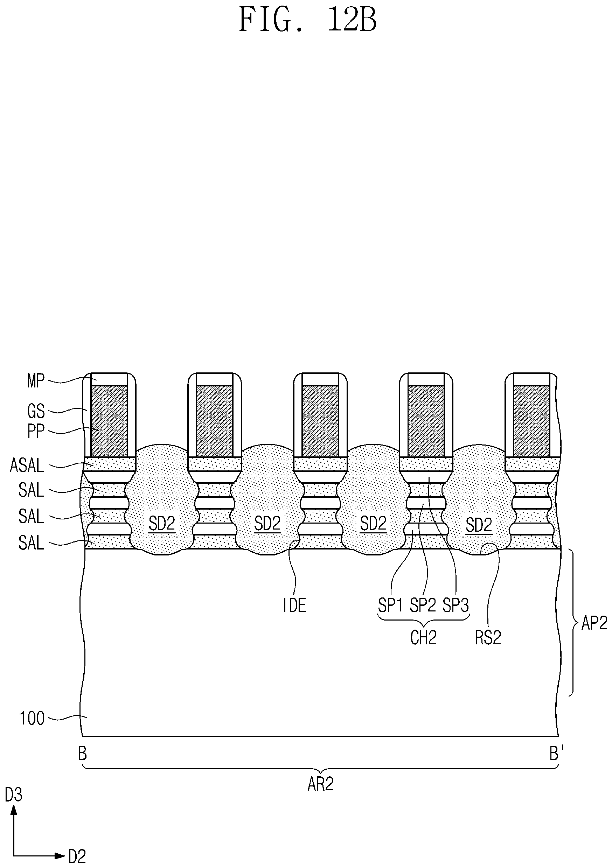

Referring to FIGS. 12A to 12C, first source/drain patterns SD1 may be correspondingly formed in the first recesses RS1. For example, a selective epitaxial growth (SEG) process may be performed in which an inner sidewall of the first recess RS1 is used as a seed layer to form an epitaxial layer that fills the first recess RS1. The epitaxial layer may be grown from a seed or the substrate 100 and the first, second, and third semiconductor patterns SP1, SP1, and SP3 exposed by the first recess RS1. For example, the SEG process may include chemical vapor deposition (CVD) or molecular beam epitaxy (MBE).

In an embodiment, the first source/drain pattern SD1 may include the same semiconductor element (e.g., Si) as that of the substrate 100. While the first source/drain pattern SD1 is formed, impurities (e.g., phosphorus, arsenic, or antimony) may be in-situ implanted to allow the first source/drain pattern SD1 to have an n-type. In some implementations, after the first source/drain pattern SD1 is formed, impurities may be doped into the first source/drain pattern SD1.

Second source/drain patterns SD2 may be correspondingly formed in the second recesses RS2. For example, a selective epitaxial growth (SEG) process may be performed such that an inner sidewall of the second recess RS2 is used as a seed to form the second source/drain pattern SD2.

In an embodiment, the second source/drain pattern SD2 may include a semiconductor element (e.g., SiGe) whose lattice constant is greater than that of a semiconductor element of the substrate 100. While the second source/drain pattern SD2 is formed, impurities (e.g., boron, gallium, or indium) may be in-situ implanted to allow the second source/drain pattern SD2 to have a p-type. In some implementations, after the formation of the second source/drain pattern SD2, impurities may be implanted into the second source/drain pattern SD2.

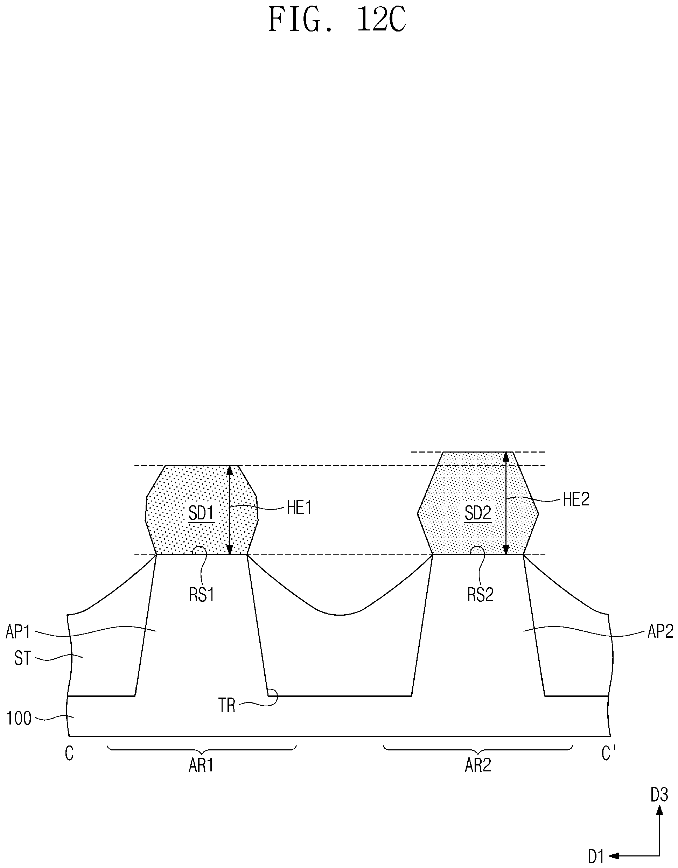

Referring back to FIG. 12C, the first source/drain pattern SD1 may have a first height HE1 in a third direction D3. The first height HE1 may be defined to indicate a length from bottom to top surfaces of the first source/drain pattern SD1. The second source/drain pattern SD2 may have a second height HE2 in the third direction D3. The second height HE2 may be defined to indicate a length from bottom to top surfaces of the second source/drain pattern SD2. The first height HE1 may be less than the second height HE2. A difference between the first height HE1 and the second height HE2 may be the same as a thickness of the additional sacrificial layer ASAL. In addition, a difference between the first height HE1 and the second height HE2 may be the same as a height in the third direction D3 of a lower portion (see GDP of FIG. 5B) of the outer electrode (see PO4 of FIG. 5B) included in the second gate electrode (see GE2 of FIG. 5B).

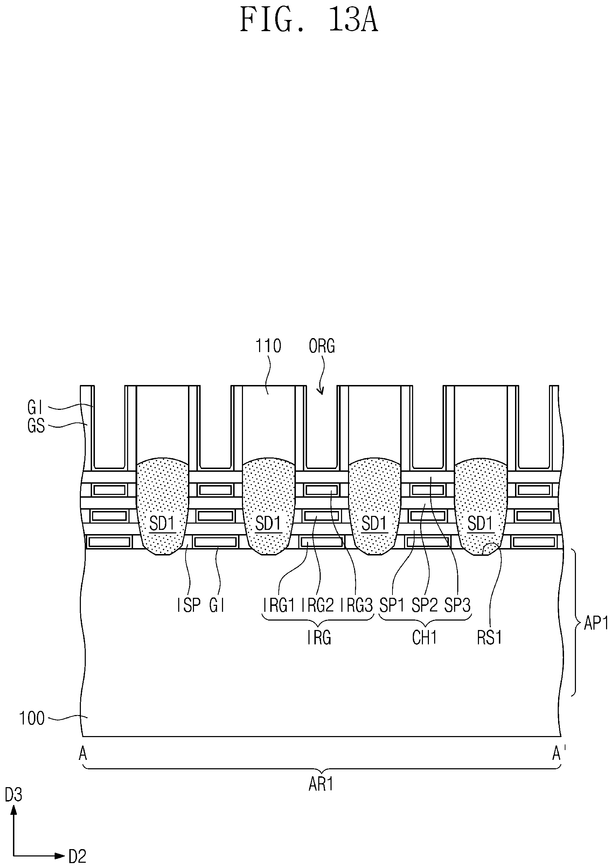

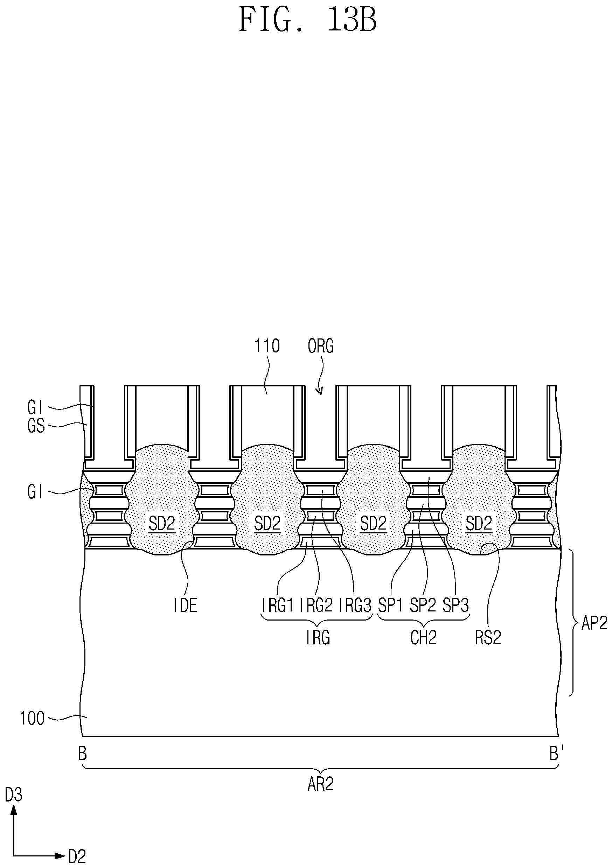

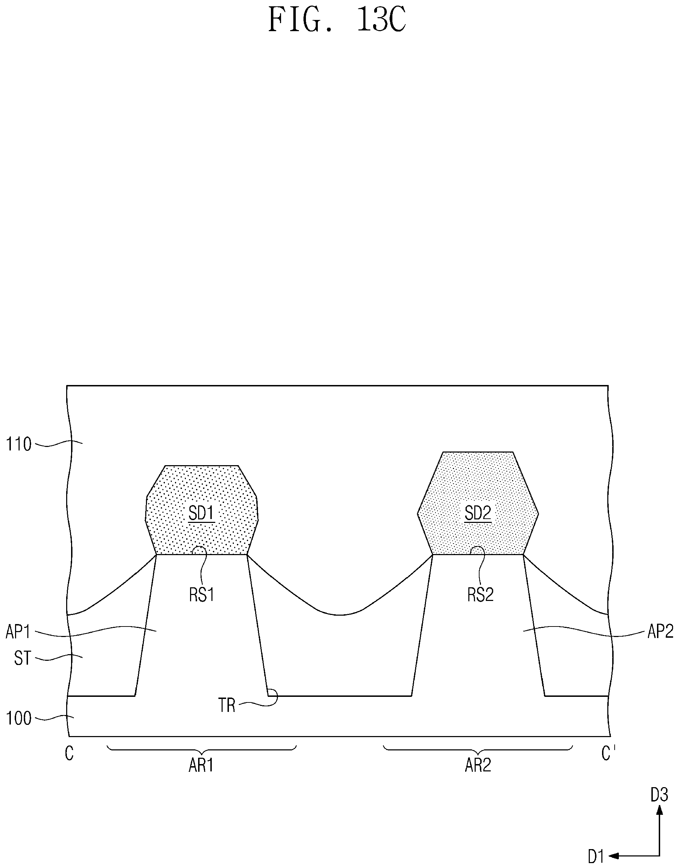

Referring to FIGS. 13A to 13D, a first interlayer dielectric layer 110 may be formed to cover the first and second source/drain patterns SD1 and SD2, the hardmask patterns MP, and the gate spacers GS. For example, the first interlayer dielectric layer 110 may include a silicon oxide layer.

The first interlayer dielectric layer 110 may be planarized until top surfaces of the sacrificial patterns PP are exposed. An etch-back or chemical mechanical polishing (CMP) process may be employed to planarize the first interlayer dielectric layer 110. The hardmask patterns MP may all be removed during the planarization process. As a result, the first interlayer dielectric layer 110 may have a top surface coplanar with those of the sacrificial patterns PP and those of the gate spacers GS.

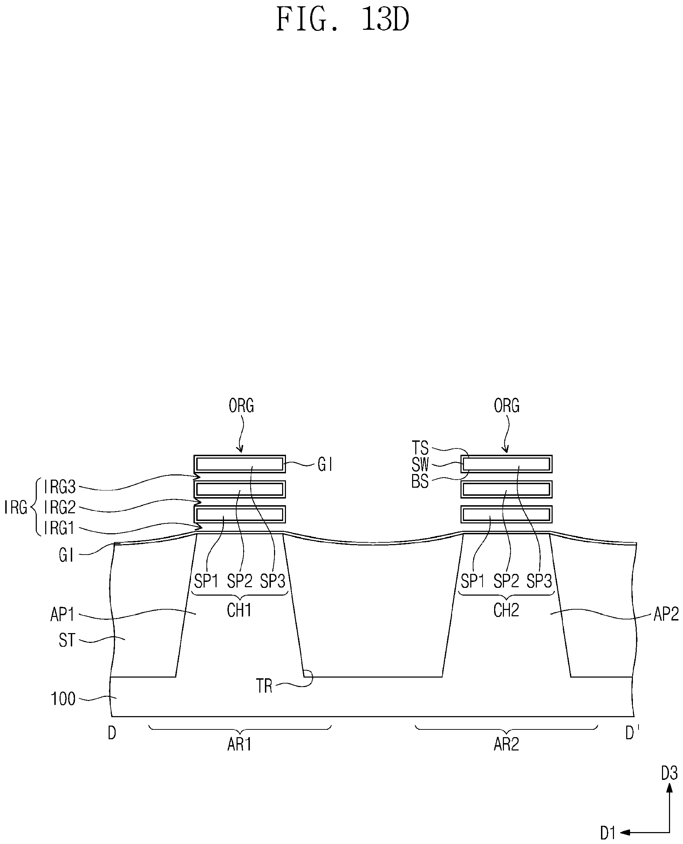

The exposed sacrificial patterns PP may be selectively removed. The removal of the sacrificial patterns PP may form an outer region ORG that exposes the first and second channel patterns CH1 and CH2 (see FIG. 13D). The removal of the sacrificial patterns PP may include performing a wet etching process using an etchant that selectively etches polysilicon.

The sacrificial layers SAL and the additional sacrificial layer ASAL exposed through the outer region ORG may be selectively removed to form inner regions IRG (see FIG. 13D). For example, an etching process that selectively etches the sacrificial layers SAL and the additional sacrificial layer ASAL may be performed such that only the sacrificial layers SAL and the additional sacrificial layer ASAL are removed while leaving the first, second, and third semiconductor patterns SP1, SP2, and SP3. The etching process may have a high etch rate with respect to silicon-germanium having a relatively high germanium concentration. For example, the etching process may have a high etch rate with respect to silicon-germanium whose germanium concentration is greater than about 10 at%.

The etching process may remove the sacrificial layers SAL and the additional sacrificial layer ASAL on the first and second active regions AR1 and AR2. The etching process may be a wet etching process. An etching material used for the etching process may promptly etch the sacrificial layer SAL and the additional sacrificial layer ASAL each of whose germanium concentration is relatively high.

Referring back to FIG. 13D, as the sacrificial layers SAL and the additional sacrificial layer ASAL may be relatively removed, such that only the first, second, and third semiconductor patterns SP1, SP2, and SP3 may remain on each of the first and second active patterns AP1 and AP2. The removal of the sacrificial layers SAL and the additional sacrificial layer ASAL may form first, second, and third inner regions IRG1, IRG3, and IRG3.

For example, the first inner region IRG1 may be formed between the active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3.

Referring back to FIGS. 13A to 13D, a gate dielectric layer GI may be formed on the exposed first, second, and third semiconductor patterns SP1, SP2, and SP3. The gate dielectric layer GI may be formed to surround each of the first, second, and third semiconductor patterns SP1, SP2, and SP3. The gate dielectric layer GI may be formed in each of the first, second, and third inner regions IRG1, IRG2, and IRG3. A gate dielectric layer GI may be formed in the outer region ORG. The gate dielectric layer GI formed in the outer region ORG may have an inverted T shape. For example, the gate dielectric layer GI may extend from a bottom surface of the outer region ORG to the gate spacer GS and a lateral surface of the second source/drain pattern SD2.

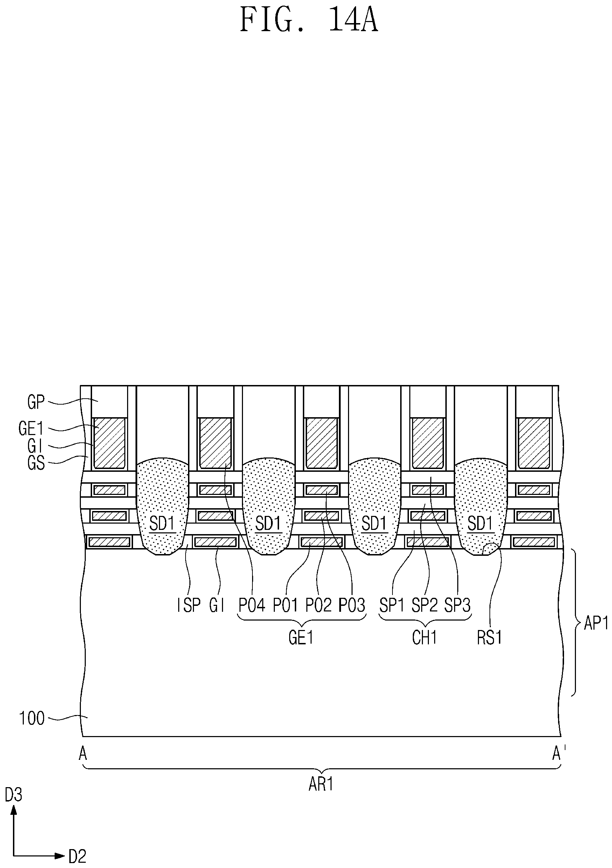

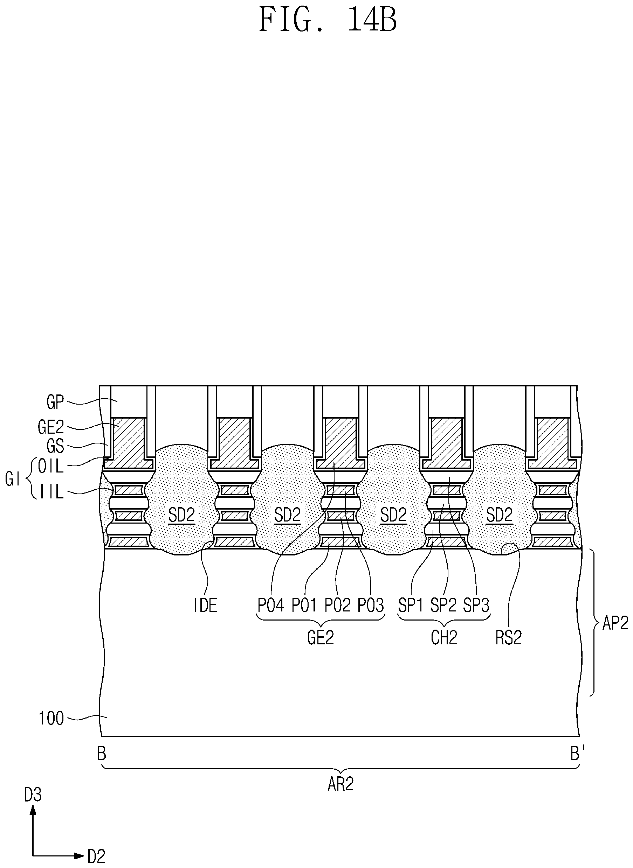

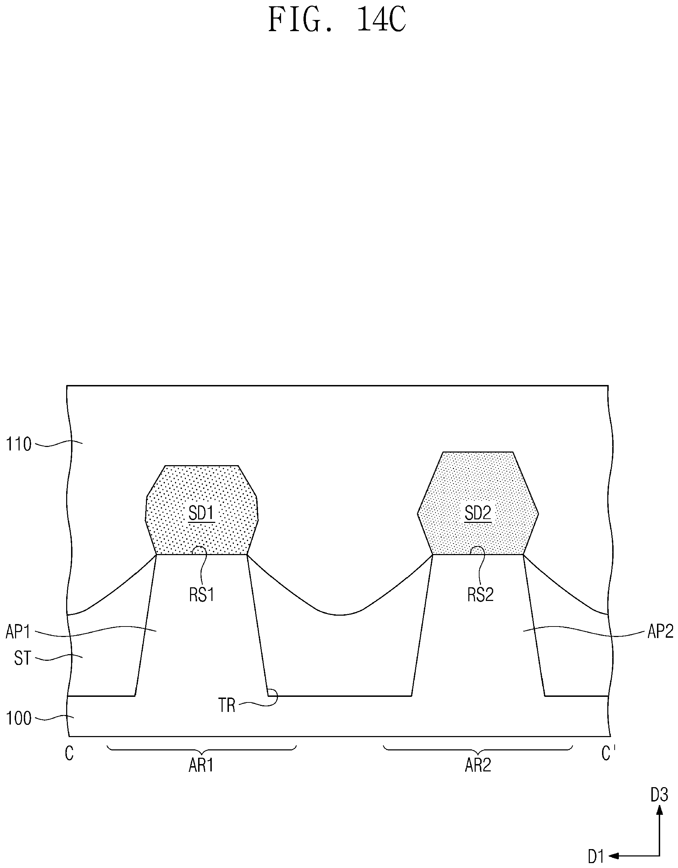

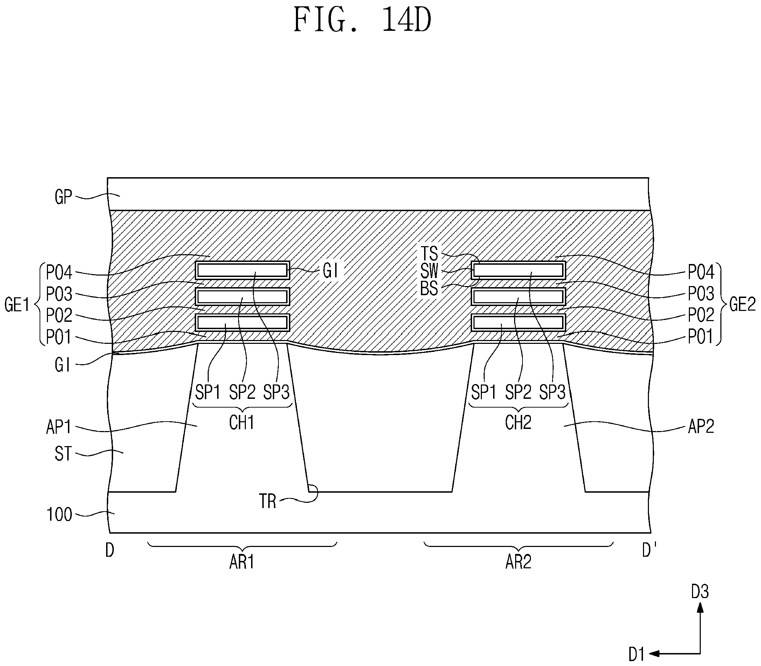

Referring to FIGS. 14A to 14D, a first gate electrode GE1 may be formed on the gate dielectric layer GI on the first active pattern AP1. For example, the first gate electrode GE1 may be formed on a high-k dielectric layer (see HK of FIG. 6A). Ahigh-k dielectric layer may be formed on the gate dielectric layer GI, and the first gate electrode GE1 may be formed on the high-k dielectric layer. The first gate electrode GE1 may include first, second, and third inner electrodes PO1, PO2, and PO3 that are respectively formed in the first, second, and third inner regions IRG1, IRG2, and IRG3, and may also include an outer electrode PO4 formed in the outer region ORG. The first gate electrode GE1 may be recessed to have a reduced height. A gate capping pattern GP may be formed on the recessed first gate electrode GE1.

A second gate electrode GE2 may be formed on the gate dielectric layer GI on the second active pattern AP2. For example, the second gate electrode GE2 may be formed on the high-k dielectric layer (see HK of FIG. 6B). A high-k dielectric layer may be formed on the gate dielectric layer GI, and the second gate electrode GE2 may be formed on the high-k dielectric layer. The second gate electrode GE2 may be formed on an outer gate dielectric layer OIL and an inner gate dielectric layer IIL. The second gate electrode GE2 may include first, second, and third inner electrodes PO1, PO2, and PO3 that are respectively formed in the first, second, and third inner regions IRG1, IRG2, and IRG3, and may also include an outer electrode PO4 formed in the outer region ORG. The outer electrode PO4 may have an inverted T shape. The outer electrode PO4 and the outer gate dielectric layer OIL may together have an inverted T shape.

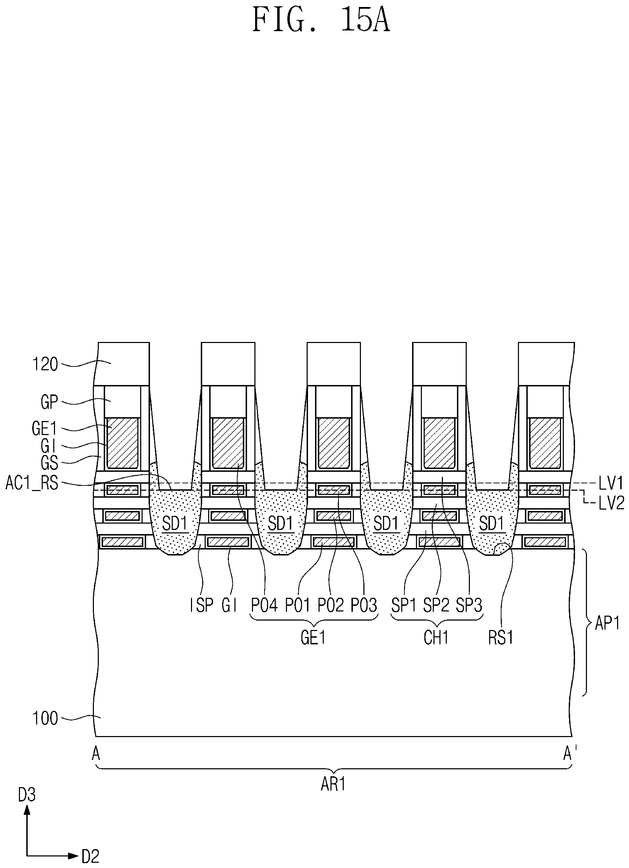

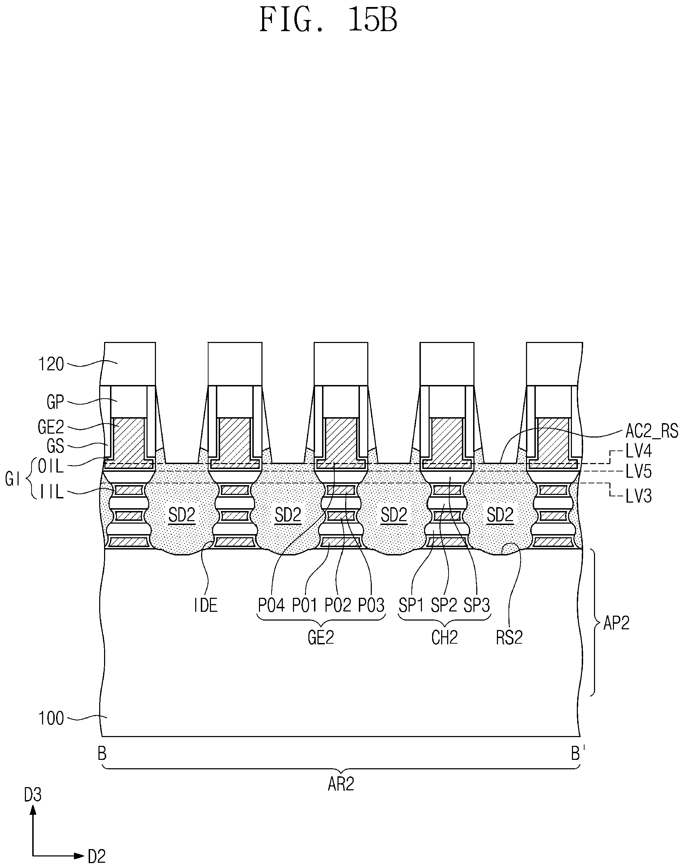

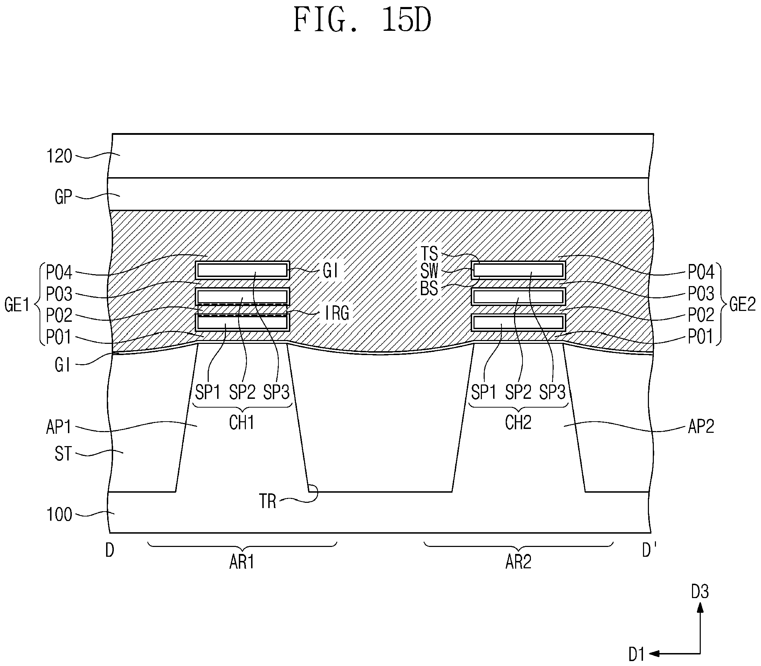

Referring to FIGS. 15A to 15D, a second interlayer dielectric layer 120 may be formed on the first interlayer dielectric layer 110. The second interlayer dielectric layer 120 may include a silicon oxide layer. First and second recess regions AC1_RS and AC2_RS may be formed to penetrate the second interlayer dielectric layer 120 and the first interlayer dielectric layer 110. The first and second recess regions AC1_RS and AC2_RS may be formed by performing a dry etching process.

The first recess region AC1_RS may penetrate the first and second interlayer dielectric layers 110 and 120 to extend to an upper portion of the first source/drain pattern SD1. For example, the first recess region AC1_RS may be formed to be inserted into the first source/drain pattern SD1. The first recess region AC1_RS may have a bottom surface lower than that of the third semiconductor pattern SP3. Aposition level LV2 in the third direction D3 of the bottom surface of the first recess region AC1_RS may be the same as the second level LV2 of FIG. 5A. Aposition level LV1 in the third direction D3 of the bottom surface of the third semiconductor pattern SP3 may be the same as the first level LV1 of FIG. 5A.

The second recess region AC2_RS may penetrate the first and second interlayer dielectric layers 110 and 110 to extend to an upper portion of the second source/drain pattern SD2. For example, the second recess region AC2_RS may be formed to be inserted into the second source/drain pattern SD2. The second recess region AC2_RS may have a bottom surface higher than that of the third semiconductor pattern SP3. The bottom surface of the second recess region AC2_RS may be higher than a top surface of the third semiconductor pattern SP3. A position level LV4 in the third direction D3 of the bottom surface of the second recess region AC2_RS may be the same as the fourth level LV4 of FIG. 5B. A position level LV3 in the third direction D3 of the bottom surface of the third semiconductor pattern SP3 may be the same as the third level LV3 of FIG. 5B. A position level LV5 in the third direction D3 of the top surface of the third semiconductor pattern SP3 may be the same as the fifth level LV5 of FIG. 5B.

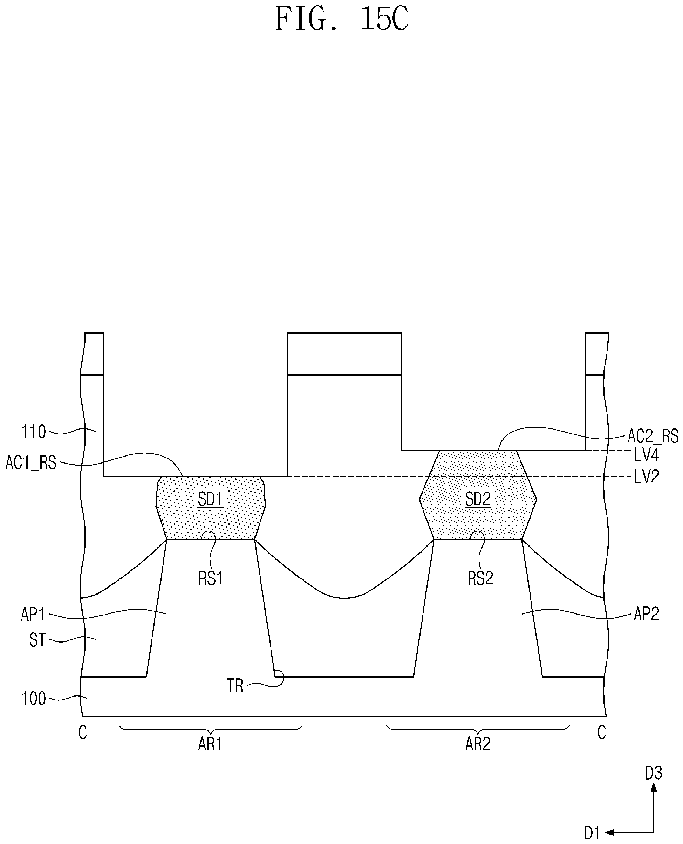

Referring back to FIG. 15C, the position level LV2 of the bottom surface of the first recess region AC1_RS may be lower than the position level LV4 of the bottom surface of the second recess region AC2_RS. This may be due to the fact that the additional sacrificial layer ASAL remains on the second active region AR2 in the previous process, and thus an etching amount is greater on an NMOSFET region than on a PMOSFET region.

Because the additional sacrificial layer ASAL is formed on the second active pattern AP2, and because the second source/drain pattern SD2 has a height higher than that of the first source/drain pattern SD1, an etching amount of the first source/drain pattern SD1 on an NMOSFET region may be greater than that of the second source/drain pattern SD2 on a PMOSFET region. When an amount of etching is adjusted based on location, it may be possible to control resistance values of the first and second source/drain patterns SD1 and SD2. In addition, the second source/drain pattern SD2 on the PMOSFET region may adjust a resistance value while maintaining a compressive stress applied to the second channel pattern CH2.

Referring back to FIGS. 5A to 5D, first and second active contacts AC1 and AC2 may be formed to penetrate the second interlayer dielectric layer 120 and the first interlayer dielectric layer 110 to come into electrical connection with the first and second source/drain patterns SD1 and SD2. A gate contact GC may be formed to penetrate the second interlayer dielectric layer 120 and the gate capping pattern GP to come into electrical connection with the gate electrode GE1 or GE2.

The formation of the first and second active contacts AC1 and AC2 and the gate contact GC may include forming barrier patterns BM1, BM2, and BM and forming conductive patterns FM1, FM2, and FM on the barrier patterns BM1, BM2, and BM. The barrier patterns BM1, BM2, and BM may be conformally formed and may include a metal layer and a metal nitride layer. The conductive patterns FM1, FM2, and FM may include metal whose resistance is low.

Separation structures DB may be correspondingly formed on first and second boundaries BD1 and BD2 of the single height cell SHC. The separation structure DB may extend from the second interlayer dielectric layer 120 through the gate electrode GE1 or GE2 into the active pattern AP1 or AP2. The separation structure DB may include a dielectric material, such as a silicon oxide layer or a silicon nitride layer.

A third interlayer dielectric layer 130 may be formed on the gate contacts GC and the first and second active contacts AC1 and AC2. A first metal layer M1 may be formed in the third interlayer dielectric layer 130. A fourth interlayer dielectric layer 140 may be formed on the third interlayer dielectric layer 130. A second metal layer M2 may be formed in the fourth interlayer dielectric layer 140.

In a three-dimensional field effect transistor according to embodiments, an etching amount of source/drain patterns may be adjusted based on NMOSFET/PMOSFET regions, and thus resistance values of the source/drain patterns may be controlled. In addition, the source/drain pattern on the PMOSFET region may adjust a resistance value while maintaining a compressive stress applied to a channel pattern. The present embodiments may adjust an etching amount of the source/drain pattern to improve reliability and electrical properties of semiconductor devices.

By way of summation and review, embodiments provide a semiconductor device having increased reliability and improved electrical properties.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device, comprising:
a substrate that includes an active pattern;
a channel pattern on the active pattern, the channel pattern including a plurality of semiconductor patterns that are spaced apart from and vertically stacked on each other;
a source/drain pattern connected to the plurality of semiconductor patterns each of which has a p-type conductivity;
a gate electrode on the plurality of semiconductor patterns, the gate electrode including inner electrodes between neighboring ones of the plurality of semiconductor patterns and an outer electrode on an uppermost semiconductor pattern of the plurality of semiconductor patterns; and
a gate dielectric layer between the gate electrode and the plurality of semiconductor patterns, the gate dielectric layer including an inner gate dielectric layer adjacent to the inner electrode and an outer gate dielectric layer that extends from a bottom surface of the outer electrode to a lateral surface of the outer electrode,
wherein the outer electrode and the outer gate dielectric layer have an inverted T shape.

2. The semiconductor device as claimed in claim 1, wherein:
the outer electrode includes a lower portion and an upper portion, the upper portion being on the lower portion, and
the lower portion extends toward the source/drain pattern.

3. The semiconductor device as claimed in claim 1 or 2, wherein:
the outer electrode includes a lower portion and an upper portion on the lower portion, and
a first width of the lower portion is greater than a second width of the upper portion.

4. The semiconductor device as claimed in claim 3, wherein the first width is greater than a width of each of the inner electrodes.

5. The semiconductor device as claimed in any preceding claim, wherein a portion of a lateral surface of the outer gate dielectric layer is in direct contact with the source/drain pattern.

6. The semiconductor device as claimed in any preceding claim, further comprising a high-k dielectric layer between the gate electrode and the gate dielectric layer, wherein the high-k dielectric layer has a uniform thickness.

7. The semiconductor device as claimed in preceding claim, further comprising:
an active contact on the source/drain pattern;
a metal-semiconductor compound layer between the active contact and the source/drain pattern; and
a gate contact on the gate electrode,
wherein:
the gate contact is electrically connected to the gate electrode, and
a bottom surface of the gate contact is coupled to a top surface of the outer electrode of the gate electrode.

8. The semiconductor device as claimed in claim 7, wherein the active contact includes:
a conductive pattern;
a barrier pattern that surrounds the conductive pattern; and
an upper dielectric pattern on the conductive pattern and the barrier pattern.

9. The semiconductor device as claimed in any preceding claim, wherein a sidewall of the source/drain pattern has a wave-shape profile.

10. The semiconductor device as claimed in claim 7, 8 or 9, wherein the source/drain pattern has a recess depth defined the active contact,
wherein the recess depth is in a range about 5.0 nm to about 7.0nm.

11. The semiconductor device as claimed in any one of claims 7 to 10, wherein the channel pattern includes a first semiconductor pattern, a second semiconductor pattern, and a third semiconductor pattern that are sequentially stacked,
wherein a bottom surface of the active contact is higher than a top surface of the third semiconductor pattern.

12. The semiconductor device as claimed in claim 11, wherein:
the outer electrode includes a lower portion and an upper portion on the lower portion, and
the bottom surface of the active contact is lower than the upper portion of the outer electrode.

13. The semiconductor device as claimed in claim 12, wherein the lower portion extends toward the source/drain pattern.
